# EUROPEAN PATENT APPLICATION

(11) **EP 4 745 822 A1**
(43) Date of publication of application: **20.05.2026**
(21) Application number: 24890216.5
(22) Date of filing: 09.08.2024
(51) Int. Cl.: G06F 30/10

(54) **METHOD AND APPARATUS FOR PROCESSING VIRTUAL COMPONENT, ELECTRONIC DEVICE, COMPUTER-READABLE STORAGE MEDIUM, AND COMPUTER PROGRAM PRODUCT**

(30) Priority: 14.11.2023 CN 202311510952
(71) Applicant: Tencent Technology (Shenzhen) Company Limited, Shenzhen, Guangdong 518057 (CN)
(72) Inventor: HU, Kaimo, Shenzhen, Guangdong 518057 (CN)
(74) Representative: Gunzelmann, Rainer
(86) International application number: PCT/CN2024/111217
(87) International publication number: WO 2025/102852

(57) **Abstract**

This application provides a method and an apparatus for processing a virtual component, a device, and a computer-readable storage medium. The method includes: acquiring a to-be-processed component, and performing preprocessing on the to-be-processed component to obtain a first alpha wrapping result of the to-be-processed component; performing triangulation processing on the first alpha wrapping result to obtain a triangulation processing result; performing double-layer structure detection on the to-be-processed component based on the triangulation processing result and the first alpha wrapping result to obtain a detection result; grouping vertices comprised in the first alpha wrapping result into a first vertex set located on a first surface and a second vertex set located on a second surface when the detection result indicates that the to-be-processed component comprises the first surface and the second surface that meet a parallel condition; and performing coplanar fitting on the first surface and the second surface based on the first vertex set and the second vertex set to obtain a target fitting result.

## Description

### RELATED APPLICATION

This application is based on and claims priority to Chinese Patent Application No. 202311510952.3 filed on November 14, 2023, which is incorporated by reference in its entirety.

### FIELD OF THE TECHNOLOGY

This application relates to the data processing technology, and in particular, to a method and an apparatus for processing a virtual component, an electronic device, a computer-readable storage medium, and a computer program product.

### BACKGROUND OF THE DISCLOSURE

In a game scene, a virtual reality scene, or an augmented reality scene, after a virtual model is generated to obtain a topology structure of the virtual model, to enable the virtual model to have a better topology structure and more appropriate surface distribution, a model needs to be reconstructed and presented by using a retopology technology. Retopology includes automatic retopology and manual retopology. In the related art, the automatic retopology has a large error when coplanar fitting is performed on model components having a double-layer structure, and the manual retopology is required. When a model structure is complex, the workload of coplanar fitting by manual retopology is huge, and the efficiency is low.

### SUMMARY

Embodiments of this application provide a method and an apparatus for processing a virtual object, an electronic device, a computer-readable storage medium, and a computer program product, which can improve the processing efficiency of coplanar fitting for an object with a double-layer structure.

Technical solutions in the embodiments of this application are implemented as follows:
An embodiment of this application provides a method for processing a virtual object, applied to an electronic device, and the method including:
acquiring a to-be-processed object, and performing preprocessing on the to-be-processed object to obtain a first alpha wrapping result of the to-be-processed object;
performing triangulation processing on the first alpha wrapping result to obtain a triangulation processing result;
performing double-layer structure detection on the to-be-processed object based on the triangulation processing result and the first alpha wrapping result to obtain a detection result;
grouping vertices included in the first alpha wrapping result into a first vertex set located on a first surface and a second vertex set located on a second surface when the detection result indicates that the to-be-processed object includes the first surface and the second surface that meet a parallel condition; and
performing coplanar fitting on the first surface and the second surface based on the first vertex set and the second vertex set to obtain a target fitting result.

An embodiment of this application provides an apparatus for processing a virtual object, including:
a preprocessing module, configured to acquire a to-be-processed object, and perform preprocessing on the to-be-processed object to obtain a first alpha wrapping result of the to-be-processed object;
a triangulation processing module, configured to perform triangulation processing on the first alpha wrapping result to obtain a triangulation processing result;
a double-layer structure detection module, configured to perform double-layer structure detection on the to-be-processed object based on the triangulation processing result and the first alpha wrapping result to obtain a detection result;
a vertex grouping module, configured to group vertices included in the first alpha wrapping result into a first vertex set located on a first surface and a second vertex set located on a second surface when the detection result indicates that the to-be-processed object includes the first surface and the second surface that meet a parallel condition; and
a coplanar fitting module, configured to perform coplanar fitting on the first surface and the second surface based on the first vertex set and the second vertex set to obtain a target fitting result.

An embodiment of this application provides an electronic device, including:
a memory, configured to store computer-executable instructions; and
a processor, configured to, when executing the computer-executable instructions stored in the memory, implement the method for processing the virtual object provided in this embodiment of this application.

An embodiment of this application provides a computer-readable storage medium, having a computer program or computer-executable instructions stored therein, the computer program or the computer-executable instructions, when executed by a processor, implementing the method for processing the virtual object provided in this embodiment of this application.

An embodiment of this application provides a computer program product, including a computer program or computer-executable instructions, the computer program or computer-executable instructions, when executed by a processor, implementing the method for processing the virtual object provided in this embodiment of this application.

The embodiments of this application have the following beneficial effects:

After the to-be-processed object is acquired, the first alpha wrapping result of the to-be-processed object is first determined, so as to obtain a flat, orientable, and bi-manifold watertight mesh model without self-intersection. Then, triangulation processing is performed on the first alpha wrapping result to obtain the triangulation processing result. Then, double-layer structure detection is performed on the to-be-processed object based on the triangulation processing result and the first alpha wrapping result. When the detection result indicates that the to-be-processed object includes the first surface and the second surface that meet the parallel condition, i.e., when the detection result indicates that the to-be-processed object has a double-layer structure, the vertices included in the first alpha wrapping result are grouped into the first vertex set located on the first surface and the second vertex set located on the second surface, so that coplanar fitting is performed on the first surface and the second surface based on the first vertex set and the second vertex set, to obtain the target fitting result, where the target fitting result has a single-layer structure. That is, in the method for processing the virtual object provided in the embodiments of this application, coplanar fitting is performed on the to-be-processed object with a double-layer structure automatically only when the to-be-processed object includes the first surface and the second surface that meet the parallel condition. However, when the to-be-processed object does not have a parallel double-layer structure, that is, when the to-be-processed object does not include the first surface and the second surface that meet the parallel condition, coplanar fitting is not performed on the to-be-processed object, which can ensure the smooth execution of coplanar fitting and improve the robustness of coplanar fitting. Moreover, since the to-be-processed object for coplanar fitting has the first surface and the second surface that meet the parallel condition, the processing complexity of coplanar fitting can be reduced, so as to improve the processing efficiency of coplanar fitting.

### BRIEF DESCRIPTION OF THE DRAWINGS

FIG. 1A is a schematic diagram of part of a virtual component having a double-layer structure on a game character model.
FIG. 1B is a schematic diagram of an alpha wrapping result of a bicycle model under different parameters.
FIG. 1C is a schematic diagram of 3D delaunay triangulation results of a sphere and a cube.
FIG. 1D is a schematic diagram of fitting results of a model in different dimensions by using a PCA method.
FIG. 2 is a schematic diagram of a network architecture of a model processing system provided in an embodiment of this application.
FIG. 3 is a structural schematic diagram of a server 400 provided in an embodiment of this application.
FIG. 4A is an implementation flowchart of a method for processing a virtual component provided in an embodiment of this application.
FIG. 4B is an implementation flowchart of preprocessing for a to-be-processed component provided in an embodiment of this application.
FIG. 4C is an implementation flowchart of double-layer detection provided in an embodiment of this application.
FIG. 5A is an implementation flowchart of vertex grouping provided in an embodiment of this application.
FIG. 5B is an implementation flowchart for classifying endpoints of remaining first connection edges provided in an embodiment of this application.
FIG. 5C is an implementation flowchart for classifying other vertices in a target wrapping result provided in an embodiment of this application.
FIG. 6 is an implementation flowchart of coplanar fitting for the first surface and the second surface provided in an embodiment of this application.
FIG. 7 is an implementation flowchart for determining an initial coplanar fitting result from a moved first surface and a moved second surface based on minimum distances provided in an embodiment of this application.
FIG. 8 is a schematic diagram of an original model and a generated flat alpha wrapping result provided in an embodiment of this application.
FIG. 9 is a schematic diagram of a double-layer structure detection process provided in an embodiment of this application.
FIG. 10 is a schematic comparison diagram of original to-be-processed components having a double-layer structure and coplanar fitting results corresponding to the original to-be-processed components provided in an embodiment of this application.
FIG. 11 is a schematic comparison diagram of cut piece structures and coplanar fitting results corresponding to the cut piece structures provided in an embodiment of this application.
FIG. 12 is a schematic comparison diagram of feather components having a double-layer structure and coplanar fitting results corresponding to the feather components provided in an embodiment of this application.

### DESCRIPTION OF EMBODIMENTS

To make the purpose, technical solutions, and advantages of this application clearer, this application will be further described below in detail in combination with the drawings. The described embodiments are not to be construed as limitations on this application. All other embodiments obtained by a person skilled in the art without contributing creative efforts shall fall within the protection scope of this application.

"Some embodiments" involved in the following description describes a subset of all possible embodiments. However, "some embodiments" may be same or different subsets of all the possible embodiments, and may be combined with each other when there is no conflict.

In the following description, the involved terms "first" and "second" are merely intended to distinguish similar objects but do not indicate a specific order for the objects. The terms "first" and "second" may be interchangeable in a specific order or sequence when permitted, so that the embodiments of this application described herein can be implemented in an order other than those shown or described herein.

In the embodiments of this application, a term "module" or "unit" refers to a computer program having predetermined functions or a part of the computer program, which operates with other relevant portions to achieve a predetermined objective, and which may be fully or partially implemented by using software, hardware (such as a processing circuit or a memory), or a combination thereof. Similarly, one processor (or a plurality of processors or memories) may be configured to implement one or more modules or units. In addition, each module or unit may be a part of an overall module or unit including functions of the module or unit.

Unless otherwise defined, all technical and scientific terms used in the embodiments of this application have the same meanings as those generally understood by a person skilled in the art in this application. The terms used in the embodiments of this application are intended to merely describe the embodiments of this application, not to limit this application.

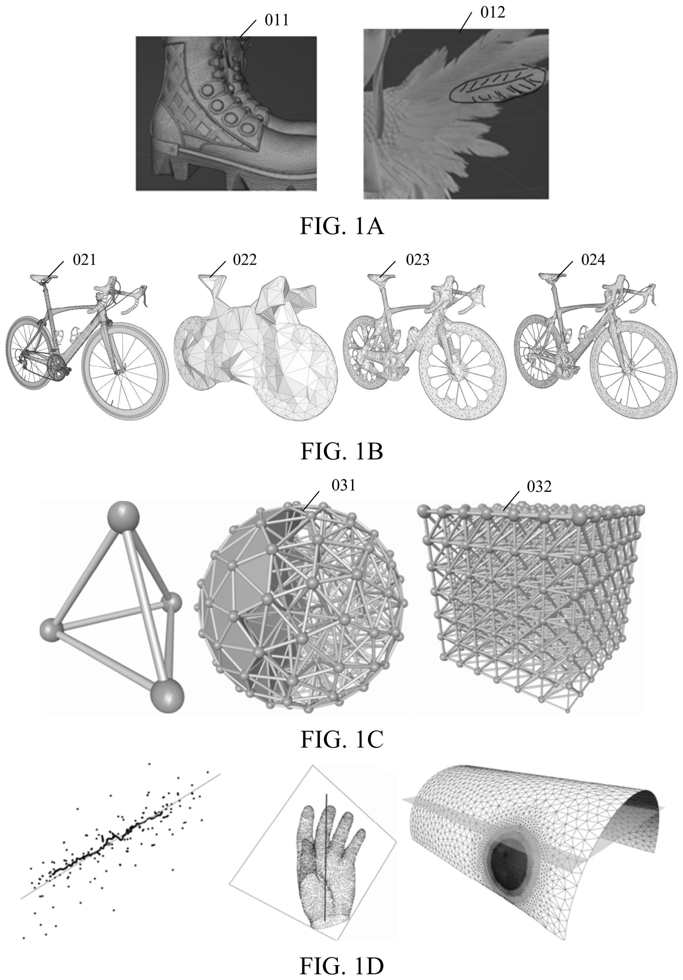

Before the embodiments of this application are further described in detail, nouns and terms involved in the embodiments of this application are described, and applicable to the following explanation.
1) Component: In this embodiment of this application, the component refers to an independent connected body mesh, which may generally indicate an independent semantics (such as a shoelace and a necklace), but does not share a geometrical element (such as a surface, an edge and a vertex) with other components.
2) A model refers to a multi-connected body mesh set, which is composed of one or more components and can express higher-level semantics. For example, the model may be a virtual character model in a game, and may include a plurality of components such as shoelaces, necklaces, clothing laces, jackets, trousers and nude models.
3) Double-layer structure: Some virtual components are mainly composed of two sets of connected discrete surfaces that are close to parallel, and a distance between the two sets of connected discrete surfaces is relatively close. Such virtual components have a double-layer structure. FIG. 1A is a schematic diagram of part of a virtual component having a double-layer structure on a game character model. Where 011 in FIG. 1A shows a double-layer structure of a shoelace, and 012 shows a double-layer structure of an angel feather.
4) A single-layer structure is a structure composed of a set of connected discrete surfaces and having open boundaries.
5) Alpha wrapping: Given a three-dimensional body (such as a point cloud, a triangle soup and a watertight mesh model), an alpha wrapping of the body may be generated as a conservative approximation to an original three-dimensional body. The alpha wrapping is a watertight mesh model, may strictly wrap an original body, and may ensure orientability, bi-manifold, and no self-intersection. The method has been integrated into a computational geometry algorithms library (CGAL) at present. FIG. 1B is a schematic diagram of an alpha wrapping result of a bicycle model under different parameters. Where two key parameters of alpha and offset may be configured for controlling the precision and the size of the wrapping. 021 in FIG. 1B is an original bicycle model, and 022, 023, and 024 are alpha wrapping results of the bicycle model under different parameters.
6) 3D delaunay triangulation: 3D triangulation refers to a process of discretizing convex hulls of a point cloud distributed in a 3D space. Generally, a discrete result thereof may be a tetrahedron or a hexahedron. 3D delaunay triangulation is a special type of triangulation method in which a tetrahedral element is generated and a circumscribed sphere of each tetrahedral unit is ensured not to include other vertices. FIG. 1C is a schematic diagram of 3D delaunay triangulation results of a sphere and a cube, where 031 in FIG. 1C is the 3D delaunay triangulation result of the sphere, and 032 is the 3D delaunay triangulation result of the cube.
7) A bounding box is an algorithm for solving an optimal bounding space of a discrete point set. A basic thought is to approximately replace a complex geometric object with a geometric body (referred to as the bounding box) with a slightly large volume and simple characteristics.
8) An axis-aligned bounding box (AABB) (2D) is a rectangle determined by coordinate ranges of all elements in the geometric body. The bounding box is a smallest rectangle that can exactly encase the geometric body among all rectangles parallel or perpendicular to coordinate axes.
9) An AABB tree is implemented based on a K-d tree principle, and each node thereof indicates a space bounding box of a 3D geometric primitive. The data structure may quickly report whether queried primitives intersect with the primitives in the tree, as well as specific intersection types and intersection positions.
10) Coplanar fitting is a modeling technology, and is mainly configured for fitting 3D data points of the virtual model on the same plane. This technology is generally configured for creating the virtual model in computer graphics, or processing data in medical imaging. Specifically, coplanar fitting of the virtual model involves combining a plurality of 2D images or section data into a continuous 3D model. This is generally implemented by mapping a group of 2D data points to the same plane, so that the data points form a continuous model in the 3D space. By using this method, a realistic virtual model may be created and applied to various applications such as computer games, medical visualization, and virtual reality.
11) Smoothing processing refers to performing filtering or smoothing processing on a model fitting result, to remove noise and improve a visual effect of a model. The smoothing processing may be implemented through algorithms such as moving average and Gaussian filtering. These algorithms may effectively remove noise and reserve useful signals, so that the model is smoother and more natural.

To better understand the method for processing the virtual component provided in this embodiment of this application, a model fitting method and existing shortcomings in the related art are first explained.

A main thought during model fitting in the related art is: for a bounded 3D body (such as a point cloud, a 2D planar graph, and a 3D mesh model), under a metric, a low-dimensional body is found and approximately fitted, so that an error is minimum under the metric. As shown in FIG. 1D, a straight line may be found by using a principle component analysis (PCA) method to fit point cloud data on a 2D plane; and 3D point cloud data may be fitted by using a straight line, or may be fitted by using a plane. Similarly, a 3D model may be fitted by using a plane. For some simple applications, a simplified objective may be achieved through a model fitting technology. For example, a curved surface close to a plane may be approximately fitted through a plane.

In a PCA-based method, the best approximation of an original model may be achieved through a plane, and the plane has a single-layer structure indeed. However, if modeling of the original model is complex, an error of fitting by using a plane is large.

Based on this, the embodiments of this application provide a method and an apparatus for processing a virtual component, a device, a computer-readable storage medium, and a computer program product, which can improve the processing efficiency and accuracy of coplanar fitting. An exemplary application of an electronic device provided in this embodiment of this application is described below. The device provided in this embodiment of this application may be implemented as various types of user terminals, such as a notebook computer, a tablet computer, a desktop computer, a set-top box, a mobile device (for example, a mobile phone, a portable music player, a personal digital assistant, a dedicated messaging device, and a portable gaming device), a smartphone, a smart speaker, a smartwatch, a smart television, and an in-vehicle terminal, or may be implemented as a server. An exemplary application in which the device is implemented as a server will be described below.

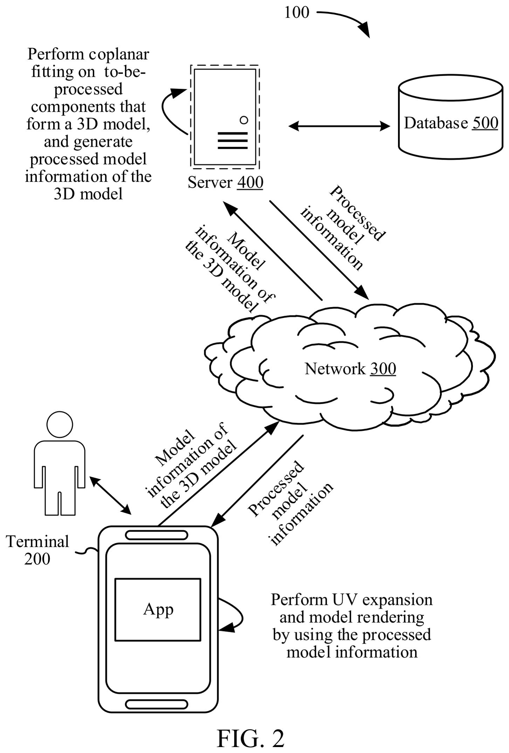

FIG. 2 is a schematic architectural diagram of a model processing system 100 provided in an embodiment of this application. As shown in FIG. 2, the model processing system 100 includes a terminal 200, a network 300, and a server 400, where the terminal 200 is connected to the server 400 through the network 300, and the network 300 may be a wide area network, a local area network, or a combination thereof. The model processing system 100 may further include a database 500, configured to store data. The database 500 may be independent of the server 400, or may be integrated with the server 400. In FIG. 2, an example in which the database 500 is independent of the server 400 is used for description.

The terminal 200 is configured to perform model design and model rendering. The terminal determines a designed 3D model of a virtual object in response to a received model design operation; then the terminal 200 transmits the 3D model to the server; the server 400 acquires model information, and determines each component included in the 3D model, which may include a garment component, an accessory component, a model body component, and the like; the server 400 respectively determines each component included in the 3D model as a to-be-processed component, and then processes each to-be-processed component by using the method for processing the virtual component provided in this embodiment of this application; when determining that the to-be-processed component includes the first surface and the second surface that meet a parallel condition, coplanar fitting is performed on the first surface and the second surface to obtain a target fitting result; and the target fitting result has a single-layer structure. That is, by using the method for processing the virtual component provided in this embodiment of this application, coplanar fitting may be performed on the to-be-processed component having a double-layer structure, to output a target fitting result having a single-layer structure. Compared with a solution in the related art in which only the to-be-processed component having a single-layer structure can be inputted to output a target fitting result having a single-layer structure, this application improves the robustness and the processing efficiency of coplanar fitting performed on the to-be-processed component having a double-layer structure. The server 400 does not perform coplanar fitting processing on a to-be-processed component that does not have the first surface and the second surface that meet a parallel condition, and directly outputs the to-be-processed component. After the server 400 performs double-layer detection on each to-be-processed component and performs fitting processing on the to-be-processed component having a double-layer structure, a processed 3D model is formed according to the target fitting result and other unprocessed to-be-processed components. The server 400 transmits processed model information to the terminal 200. The terminal 200 performs UV expansion processing on the processed model information to obtain a 2D expansion result of the processed 3D model, so as to perform 2D rendering based on the 2D expansion result. Because the component having the double-layer structure in the processed 3D model has been coplanarly fitted to a single-layer structure, the complexity of the 3D model can be greatly simplified while ensuring accuracy of the model structure, thereby improving the processing efficiency of UV expansion and 2D rendering.

In some embodiments, the server 400 may be an independent physical server, or may be a server cluster composed of a plurality of physical servers, or a distributed system, or may be a cloud server that provides basic cloud computing services such as a cloud service, a cloud database, cloud computing, a cloud function, cloud storage, a network service, cloud communication, a middleware service, a domain name service, a security service, a content delivery network (CDN), big data, and an artificial intelligence platform. The terminal 200 may be a smartphone, a tablet computer, a laptop, a desktop computer, a smart speaker, a smartwatch, an in-vehicle terminal, and the like, but is not limited thereto. The terminal and the server may be directly or indirectly connected through wired or wireless communication, which is not limited in this embodiment of this application.

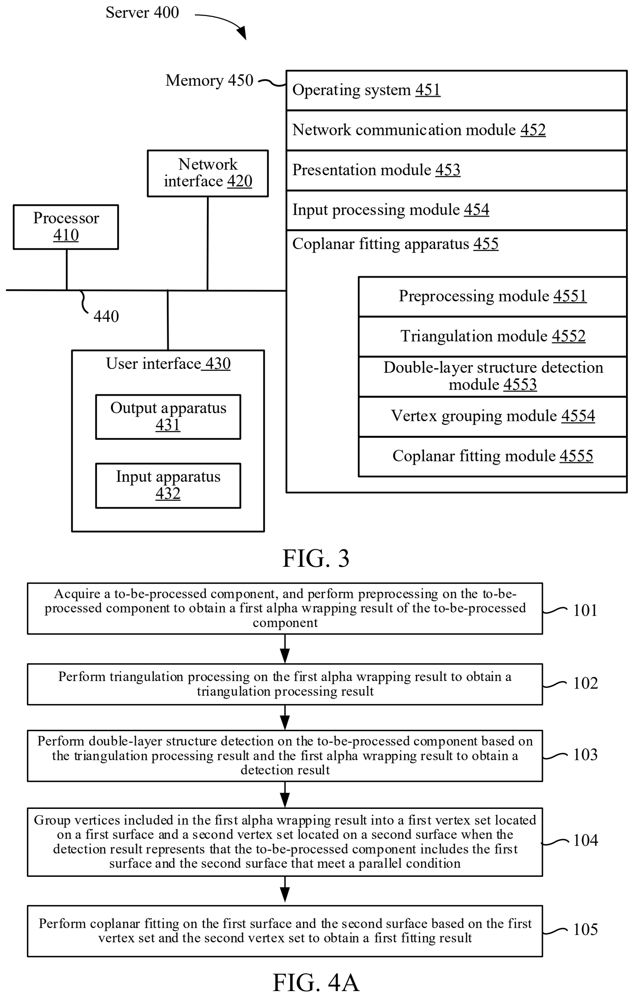

FIG. 3 is a structural schematic diagram of a server 400 provided in an embodiment of this application. The server 400 shown in FIG. 3 includes: at least one processor 410, a memory 450, at least one network interface 420, and a user interface 430. Components in the server 400 are coupled together through a bus system 440. The bus system 440 is configured to realize connection communication between the components. In addition to a data bus, the bus system 440 further includes a power bus, a control bus, and a status signal bus. However, for clear description, various buses are marked as the bus system 440 in FIG. 2.

The processor 410 may be an integrated circuit chip, and has a signal processing capability, such as a general-purpose processor, a digital signal processor (DSP), or other programmable logic devices, a discrete gate or a transistor logic device, or a discrete hardware component, where the general-purpose processor may be a microprocessor or any conventional processor.

The user interface 430 includes one or more output apparatuses 431 that enable presentation of media content, including one or more loudspeakers and/or one or more visual display screens. The user interface 430 further includes one or more input apparatuses 432, including a user interface component conducive to user input, such as a keyboard, a mouse, a microphone, a touch display screen, a camera, other input buttons, and a control.

The memory 450 may be a removable memory, a non-removable memory, or a combination thereof. Exemplary hardware devices include a solid-state memory, a hard-disk drive, an optical disc drive, and the like. In some embodiments, the memory 450 includes one or more storage devices that are physically away from the processor 410.

The memory 450 includes a volatile memory or a non-volatile memory, or may include both a volatile memory and a non-volatile memory. The non-volatile memory may be a read only memory (ROM), and the volatile memory may be a random access memory (RAM). The memory 450 described in this embodiment of this application is intended to include any suitable type of memory.

In some embodiments, the memory 450 can store data to support various operations. Examples of the data include a program, a module, and a data structure, or a subset or a superset thereof, which are, for example, described below.

An operating system 451 includes system programs configured for processing various basic system services and performing hardware-related tasks, such as a framework layer, a core library layer, and a drive layer for implementing various basic services and processing hardware-based tasks.

A network communication module 452 is configured to reach other computing devices through one or more (wired or wireless) network interfaces 420. An exemplary network interface 420 includes: Bluetooth, wireless fidelity (Wi-Fi), and a universal serial bus (USB).

A presentation module 453 is configured to present information through one or more output apparatuses 431 (such as a display screen and a loudspeaker) associated with the user interface 430 (such as a user interface configured to operate a peripheral device and display content and information).

An input processing module 454 is configured to detect one or more user inputs or interactions from one or more input apparatuses 432 and translate the detected inputs or interactions.

In some embodiments, the apparatus provided in this embodiment of this application may be implemented in a software mode. FIG. 3 shows an apparatus 455 for processing a virtual component, stored in a memory 450, and the apparatus 455 may be software in the form of a program and a plugin, and includes the following software modules: a preprocessing module 4551, a triangulation processing module 4552, a double-layer structure display module 4553, a vertex grouping module 4554, and a coplanar fitting module 4555. These modules are logical, and thus may be combined or further split in different manners according to the functions to be implemented. Functions of the modules are described below.

In some other embodiments, the apparatus provided in this embodiment of this application may be implemented in a hardware mode. As an example, the apparatus provided in this embodiment of this application may be a processor in the form of a hardware decoding processor, and is programmed to perform the method for processing the virtual component provided in this embodiment of this application. For example, the processor in the form of the hardware decoding processor may adopt one or more application specific integrated circuits (ASICs), a digital signal processor (DSP), a programmable logic device (PLD), a complex programmable logic device (CPLD), a field-programmable gate array (FPGA), or other electronic elements.

The method for processing the virtual component provided in this embodiment of this application will be described in combination with the exemplary application and implementation of the server provided in this embodiment of this application.

The method for processing the virtual component provided in this embodiment of this application is described below. As described above, an electronic device for implementing the method for processing the virtual component in this embodiment of this application may be a terminal, a server, or a combination thereof. Therefore, an execution body of each operation is not repeatedly described below.

FIG. 4A is an implementation flowchart of a method for processing a virtual component provided in an embodiment of this application, which will be described in combination with operations shown in FIG. 4A. A main body of the operations in FIG. 4A is a server.

In operation 101, a to-be-processed component is acquired, and preprocessing is performed on the to-be-processed component to obtain a first alpha wrapping result of the to-be-processed component.

In some embodiments, the virtual component may be a virtual object as described above, or referred to as a model (3D model) of the virtual object; or the virtual component may be a part of the virtual object, or referred to as a model (3D model) of the part of the virtual object; a to-be-processed virtual model is first acquired; the to-be-processed virtual model may be a virtual character model, a virtual building model, a virtual prop model, and the like; the to-be-processed virtual model is composed of a plurality of virtual components; for example, a virtual character model includes virtual components such as a virtual clothing, a virtual accessory, and a virtual character; and the virtual components in the to-be-processed virtual model are sequentially determined as to-be-processed components, and processed by using the method for processing the virtual component provided in this embodiment of this application.

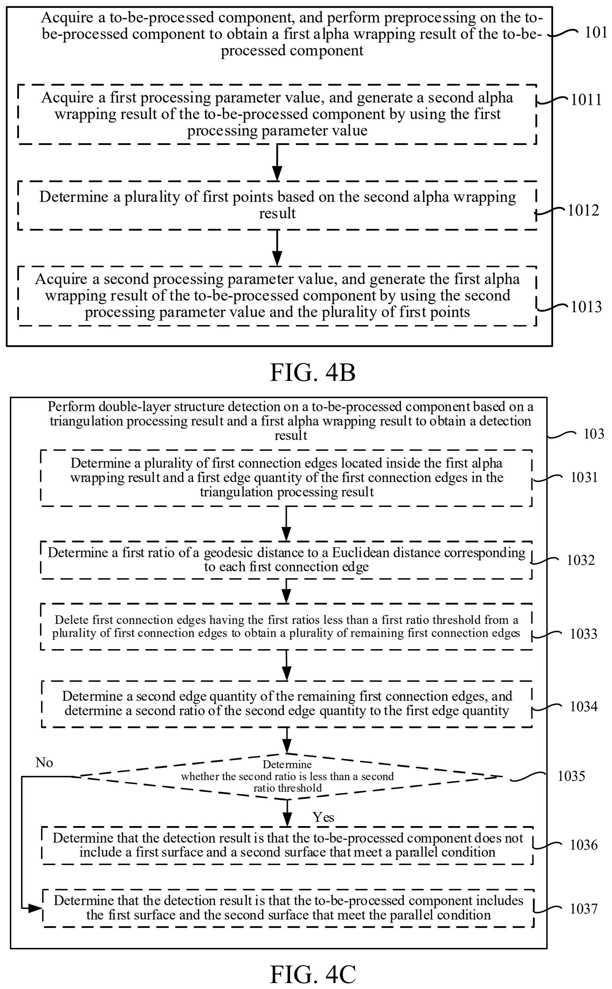

In some embodiments, as shown in FIG. 4B, "performing preprocessing on the to-be-processed component to obtain the first alpha wrapping result of the to-be-processed component" in operation 101 may be implemented through the following operation 1011 to operation 1013, and is described below with reference to FIG. 4B.

In operation 1011, a first processing parameter value is acquired, and a second alpha wrapping result of the to-be-processed component is generated by using the first processing parameter value.

In some embodiments, an AABB of the to-be-processed component is first acquired, and may be calculated by using a library function provided by the CGAL; and a diagonal length of the AABB is determined, so as to determine the first processing parameter value based on the diagonal length. The first processing parameter value includes the first size parameter value and the first offset parameter value, where the first size parameter value is configured for controlling a maximum size of a cavity which can be entered in a wrapping shrinking process; and the first offset parameter value is configured for controlling an offset degree of a final surface mesh for input, where the smaller the first offset parameter value, the smaller the offset degree of the final surface mesh relative to the input, indicating that the final surface mesh wraps the input more tightly. The fidelity of the input and the complexity of output can be balanced by using the first size parameter value and the first offset parameter value. For example, the first size parameter value may be 1/50 of the diagonal length, and the first offset parameter value may be 1/100 of the diagonal length. After the first size parameter value and the first offset parameter value are determined, the library function for generating the alpha wrapping provided by the CGAL may be called to generate the second alpha wrapping result of the to-be-processed component. Where inputs of the library function for generating the alpha wrapping include vertex data, the first size parameter value, and the first offset parameter value of the to-be-processed component, and output data is a valid (watertight, without intersection, and combined bi-manifold) surface triangular mesh including the to-be-processed component. Therefore, generating the second alpha wrapping result of the to-be-processed component may be understood as first meshing processing on the to-be-processed component, or may be understood as first triangulation processing on the to-be-processed component.

In operation 1012, a plurality of target points are determined based on the second alpha wrapping result.

Where the target points are located inside the second alpha wrapping result. In some embodiments, operation 1012 may be implemented in the following two modes:

The first mode: performing meshing processing on the second alpha wrapping result to obtain a meshed alpha wrapping result; determining vertices, midpoints of connection edges, and a center of gravity of triangular patches in the meshed alpha wrapping result as first sampling points; determining a normal of each first sampling point towards an interior of the meshed alpha wrapping result, and determining intersection points between the normals and the meshed alpha wrapping result; and determining a midpoint between each first sampling point and the corresponding intersection point, and determining the midpoints as the target points.

Because generating the second alpha wrapping result of the to-be-processed component may be understood as the first meshing processing on the to-be-processed component, and performing meshing processing on the second alpha wrapping result may be understood as the second meshing processing, remeshing processing is performed on the second alpha result.

In some embodiments, meshing processing may be performed on the second alpha wrapping result by using the library function provided by the CGAL to obtain the meshed alpha wrapping result; triangular patches included in the meshed alpha wrapping result are all regular triangles; and a difference between areas of any two triangular patches is less than an area threshold. After the meshed alpha wrapping result is obtained, the midpoints of the connection edges are determined based on the vertex coordinates of each connection edge in the meshed alpha wrapping result, and the center of gravity of the triangular patches is determined according to the vertex coordinates of triangular patches, so that the vertices, the midpoints of the connection edges, and the center of gravity of the triangular patches in the meshed alpha wrapping result are determined as the first sampling points. The normal of each first sampling point towards the interior of the meshed alpha wrapping result is calculated, the intersection points between the normals and the meshed alpha wrapping result are determined, and the midpoints between the first sampling points and the intersection points are determined as the target points. Because a normal direction is toward the interior of the alpha wrapping, and the first sampling points and the intersection points are located on the meshed alpha wrapping result, the midpoints between the first sampling points and the intersection points are certainly located inside the alpha wrapping result.

In the first implementation, the midpoints between the first sampling points and the intersection points corresponding to the normals are used as the target points, which can obtain a target point set closer to a middle of the double-layer structure, so that the alpha wrapping generated again based on a plurality of target points in the target point set is flatter, so that a subsequent detection process of the double-layer structure is more robust.

The second mode: performing uniform sampling in an internal space of the second alpha wrapping result to obtain a plurality of second sampling points; determining first minimum distances between the second sampling points and the second alpha wrapping result; and determining the second sampling points having the first minimum distances greater than or equal to a preset first distance threshold as the target points.

In some embodiments, uniform sampling may be performed in the internal space of the second alpha wrapping result according to a preset interval length, to obtain a plurality of second sampling points. Because sampling is performed in the internal space of the second alpha wrapping result, the second sampling points are certainly located inside the second alpha wrapping result. Then, for each second sampling point, rays are emitted in a plurality of preset directions, and the intersection points between the rays and the second alpha wrapping result are determined, where the preset directions may include up, down, left, and right, and may further include up left, down left, up right, and down right. Then, the distances between the second sampling points and the intersection points are determined, to determine the first minimum distance between the second sampling point and the second alpha wrapping result. When the first minimum distance corresponding to the second sampling point is less than a preset first distance threshold, the second sampling point is close to an edge of the second alpha wrapping and thus, the second sampling point is not used as the target point. If the first minimum distance corresponding to the second sampling point is greater than or equal to the first distance threshold, the second sampling point is not close to the edge of the second alpha wrapping and thus, the second sampling point is determined as the target point.

In operation 1013, the second processing parameter value is acquired, and the first alpha wrapping result of the to-be-processed component is generated by using the second processing parameter value and the plurality of target points.

In some embodiments, the second processing parameter value is similar to the first processing parameter value, and includes the second size parameter value and the second offset parameter value, and the second parameter value is less than the first parameter value, i.e., the second size parameter value is less than the first size parameter value, and the second offset parameter value is less than the second offset parameter value. Following the above example, the first size parameter value may be 1/50 of the diagonal length, and the first offset parameter value may be 1/100 of the diagonal length. Then, the second size parameter value may be 1/100 of the diagonal length, and the second offset parameter value may be 1/200 of the diagonal length. The size parameter value is configured for controlling a maximum size of a cavity which can be entered in a wrapping shrinking process, the offset parameter value is configured for controlling the compactness of a final surface mesh for input, and the second processing parameter value is less than the first processing parameter value; and therefore, the first alpha wrapping result generated by using the second processing parameter value and the target points located inside the second alpha wrapping is more compact and accurate and flatter compared with the second alpha wrapping result, so that a subsequent detection process of the double-layer structure is more robust.

The explanation is continued from operation 101 below with reference to FIG. 4A.

In operation 102, triangulation processing is performed on the first alpha wrapping result to obtain a triangulation processing result.

Because generating the second alpha wrapping result of the to-be-processed component may be understood as the first triangulation processing, and performing triangulation processing on the first alpha wrapping result may be understood as the second triangulation processing, re-triangulation processing may be performed on the first alpha wrapping result.

In some embodiments, all the vertices in the first alpha wrapping result are used as inputs, triangulation processing is performed on the first alpha wrapping result in the 3D space by using a preset triangulation function provided by the CGAL to obtain the triangulation processing result, and the triangulation processing result includes the vertices and the connection edges of triangular patches. In some embodiments, delaunay triangulation processing may be performed on the first alpha wrapping result by using a delaunay triangulation function to discretize the convex hulls of the vertices in the first alpha wrapping result. Where the convex hulls of the vertices refer to convex sets including all the vertices in the target wrapping result. In some embodiments, the triangulation processing on the first alpha wrapping result may also be implemented by using any other triangulation functions. For example, an incremental regular triangulation method is further implemented in the CGAL, and may be configured for triangulation processing on the first alpha wrapping result to obtain the triangulation processing result.

In operation 103, double-layer structure detection is performed on the to-be-processed component based on the triangulation processing result and the first alpha wrapping result to obtain a detection result.

In some embodiments, the triangulation processing result includes vertices and the connection edges of triangular patches. As shown in FIG. 4C, operation 103 may be implemented through the following operation 1031 to operation 1037, and is specifically described below.

In operation 1031, a plurality of first connection edges located inside the first alpha wrapping result and a first edge quantity of the first connection edges are determined in the triangulation processing result.

In some embodiments, connection edges located outside the first alpha wrapping, connection edges located inside the first alpha wrapping, and connection edges located on a surface of the first alpha wrapping may exist in the triangular patches obtained after the triangulation processing is performed on the first alpha wrapping. In operation 1031, the connection edges outside the first alpha wrapping result and the connection edges located on the surface of the first alpha wrapping need to be deleted. For example, an AABB tree of the first alpha wrapping result is first constructed. In some embodiments, the AABB tree of the first alpha wrapping result may be constructed by using the library function configured for constructing the AABB tree in the CGAL; the midpoint of each connection edge in the triangulation processing result is determined; then a distance between the midpoint of each connection edge in the triangulation processing result and the AABB tree is calculated; if the distance is less than a given second distance threshold (a default value of 0.001), the connection edge is considered to be located on the surface of the first alpha wrapping, and is directly deleted; and if the distance is greater than or equal to the second distance threshold, a ray casting method is used to determine whether the midpoint is located inside the first alpha wrapping. For example, rays are emitted in any direction by using the midpoint as a starting point, and the number of intersection points between the rays and the first alpha wrapping result is determined. If the number of the intersection points is even, the midpoint is located outside the first alpha wrapping result, and the connection edge is deleted; and if the number of the intersection points is odd, the midpoint is located inside the first alpha wrapping result, and the connection edge is located inside the first alpha wrapping result and is reserved.

In operation 1032, a first ratio of a geodesic distance to a Euclidean distance corresponding to each first connection edge is determined.

In some embodiments, the vertex coordinates of two vertices of each first connection edge are first acquired, and then the Euclidean distance of the first connection edge may be determined based on the vertex coordinates of the two vertices and a Euclidean distance calculation formula. The geodesic distance refers to a shortest distance for moving from a point A to a point B on a curved surface (not allowed to leave the curved surface). When the geodesic distance corresponding to the first connection edge is determined, a geodesic distance calculation function provided by the CGAL needs to be used, and the vertex coordinates of the two vertices of the first connection edge and the first alpha wrapping result are used as the inputs of the geodesic distance calculation function to obtain the geodesic distance corresponding to the first connection edge. The geodesic distance corresponding to the first connection edge is greater than or equal to the Euclidean distance corresponding to the first connection edge. Therefore, a first ratio of the geodesic distance to the Euclidean distance corresponding to the first connection edge is a real number greater than or equal to 1.

In operation 1033, first connection edges having the first ratios less than a first ratio threshold are deleted from the plurality of first connection edges to obtain a plurality of remaining first connection edges.

All the first connection edges of the first alpha wrapping may be obtained through operation 1031, but two endpoints of the first connection edge located at the boundary of the double-layer structure may not belong to different layers of the double-layer structure, which may significantly interfere with subsequent classification of the double-layer structure. Therefore, in operation 1033, screening is further performed through the first ratio of the geodesic distance to the Euclidean distance corresponding to the first connection edge, to ensure that two endpoints of the remaining first connection edges belong to different layers of the double-layer structure. A basic thought of this algorithm is: The Euclidean distance between two endpoints of the first connection edge located at the boundary of the double-layer structure is often not much different from the geodesic distance. However, geodesics of two endpoints of the first connection edge located at the central part of the double-layer structure need to pass through the edges of the entire double-layer structure, and thus are significantly longer than the Euclidean distance. Therefore, the remaining first connection edges obtained by deleting the first connection edges having the first ratios less than the first ratio threshold in operation 1033 are the first connection edges located at the central part of the double-layer structure. In some embodiments, the first ratio threshold may be 3, or may be 3.5, 4, and the like.

In operation 1034, a second edge quantity of the remaining first connection edges is determined, and a second ratio of the second edge quantity to the first edge quantity is determined.

In some embodiments, because the second edge quantity of the remaining first connection edges is less than or equal to the first edge quantity, the second ratio of the second edge quantity to the first edge quantity is a real number between 0 and 1. For example, if the first edge quantity is 100, and the second edge quantity is 70, the second ratio is 70/100 = 0.7.

In operation 1035, whether the second ratio is less than a second ratio threshold is determined.

When the second ratio is less than the second ratio threshold, operation 1036 is performed, and when the second ratio is greater than or equal to the second ratio threshold, operation 1037 is performed.

In operation 1036, the detection result is determined that the to-be-processed component does not include the first surface and the second surface that meet the parallel condition.

In some embodiments, if the second ratio is less than the second ratio threshold, a proportion of the remaining first connection edges to the first connection edges is small, and the plurality of first connection edges include fewer first connection edges located at the central part of the double-layer structure. Therefore, the to-be-processed component is considered not to include the first surface and the second surface that meet the parallel condition, i.e., the to-be-processed component does not have the double-layer structure.

In operation 1037, the detection result is determined that the to-be-processed component includes the first surface and the second surface that meet the parallel condition.

In some embodiments, if the second ratio is greater than or equal to the second ratio threshold, the proportion of the remaining first connection edges to the first connection edges is large, and the plurality of first connection edges include more first connection edges located at the central part of the double-layer structure. Therefore, the to-be-processed component is considered to include the first surface and the second surface that meet the parallel condition, i.e., the to-be-processed component has the double-layer structure.

Because for a component having a double-layer structure (i.e., having the first surface and the second surface that meet the parallel condition), only a few internal connection edges located at the boundary may be deleted in operation 1033, while for a component having no double-layer structure, a large quantity of internal connection edges are deleted because the first ratio of the geodesic distance to the Euclidean distance is less than the first ratio threshold. Therefore, in operation 1034 to operation 1037, the proportion of the deleted internal connection edges is calculated to determine whether the original to-be-processed component has a double-layer structure, and only a model having a double-layer structure is configured for subsequent classification and fitting. If determining according to the second ratio that the original to-be-processed component does not have a double-layer structure, i.e., a single-layer structure may not be configured to perform coplanar fitting, then the procedure is ended, so as to ensure that a subsequent coplanar fitting process is accurately performed.

The explanation is continued from operation 103 below with reference to FIG. 4A.

In operation 104, vertices included in the first alpha wrapping result are grouped into a first vertex set located on a first surface and a second vertex set located on a second surface when the detection result indicates that the to-be-processed component includes the first surface and the second surface that meet a parallel condition.

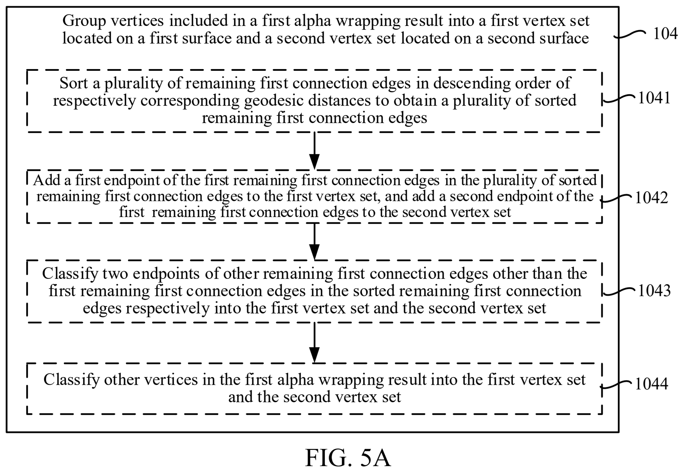

In some embodiments, as shown in FIG. 5A, "grouping vertices included in the first alpha wrapping result into the first vertex set located on the first surface and the second vertex set located on the second surface" in operation 104 may be implemented through operation 1041 to operation 1044 below, and specifically described below.

In operation 1041, the plurality of remaining first connection edges are sorted in descending order of respectively corresponding geodesic distances to obtain a plurality of sorted remaining first connection edges.

In some embodiments, the plurality of remaining first connection edges are sorted in descending order of respectively corresponding geodesic distances, i.e., sorted in an order of the geodesic distances from largest to smallest, to obtain a plurality of sorted remaining first connection edges. Where the geodesic distance of the first remaining first connection edges in the plurality of sorted remaining first connection edges is largest.

In operation 1042, a first endpoint of the first remaining first connection edges in the plurality of sorted remaining first connection edges is added to the first vertex set, and a second endpoint of the first remaining first connection edges is added to the second vertex set.

In some embodiments, the first vertex set and the second vertex set are initially empty sets, and the first endpoint of the remaining first connection edge may be any one of two endpoints of the remaining first connection edge. Therefore, in operation 1042, any one of the two endpoints of the first remaining first connection edges may be added to the first vertex set, and the other endpoint may be added to the second vertex set.

In operation 1043, two endpoints of other remaining first connection edges other than the first remaining first connection edges in the sorted remaining first connection edges are classified respectively into the first vertex set and the second vertex set.

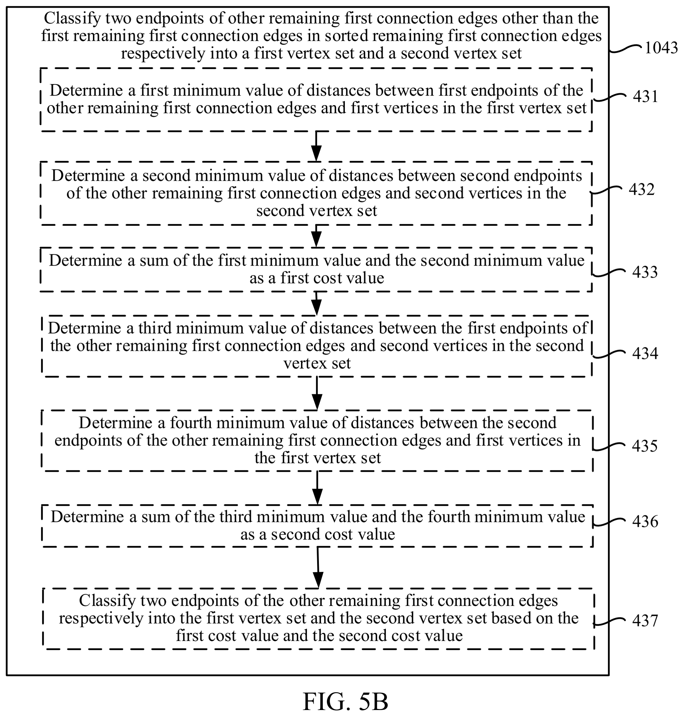

In some embodiments, the endpoints added into the first vertex set are determined as the first vertices, and the endpoints added into the second vertex set are determined as the second vertices. Two endpoints of each other remaining first connection edge may be classified respectively into the first vertex set and the second vertex set through operation 431 to operation 437 shown in FIG. 5B, which is described below in detail.

In operation 431, a first minimum value of distances between first endpoints of the other remaining first connection edges and first vertices in the first vertex set is determined.

In some embodiments, the Euclidean distances between the first endpoints and each first vertex may be determined according to the endpoint coordinates of the first endpoints of the other remaining first connection edges and the vertex coordinates of each first vertex in the first vertex set, and a minimum Euclidean distance therein is determined as the first minimum value.

In operation 432, a second minimum value of distances between second endpoints of the other remaining first connection edges and second vertices in the second vertex set is determined.

In some embodiments, similar to operation 431, the Euclidean distances between the second endpoints and each second vertex may be determined according to the endpoint coordinates of the second endpoints of the other remaining first connection edges and the vertex coordinates of each second vertex in the second vertex set, and a minimum Euclidean distance therein is determined as the second minimum value.

In operation 433, a sum of the first minimum value and the second minimum value is determined as a first cost value.

In some embodiments, the first cost value indicates a cost value of adding the first endpoints of the other remaining first connection edges into the first vertex set, and adding the second endpoints into the second vertex set.

In operation 434, a third minimum value of distances between the first endpoints of the other remaining first connection edges and second vertices in the second vertex set is determined.

In some embodiments, the Euclidean distances between the first endpoints and each second vertex are determined according to the endpoint coordinates of the first endpoints of the other remaining first connection edges and the vertex coordinates of each second vertex in the second vertex set, and a minimum Euclidean distance is determined as the third minimum value.

In operation 435, a fourth minimum value of distances between the second endpoints of the other remaining first connection edges and first vertices in the first vertex set is determined.

In some embodiments, the Euclidean distances between the second endpoints and each first vertex are determined according to the endpoint coordinates of the second endpoints of the other remaining first connection edges and the vertex coordinates of each first vertex in the first vertex set, and a minimum Euclidean distance is determined as the fourth minimum value.

In operation 436, a sum of the third minimum value and the fourth minimum value is determined as a second cost value.

Where the second cost value indicates a cost value of adding the first endpoints of the other remaining first connection edges into the second vertex set, and adding the second endpoints into the first vertex set.

In operation 437, two endpoints of the other remaining first connection edges are classified respectively into the first vertex set and the second vertex set based on the first cost value and the second cost value.

In some embodiments, when the first cost value is less than the second cost value, a sum of the minimum distances between the first endpoints of the remaining first connection edges and each first vertex in the first vertex set and the minimum distances between the second endpoints and each second vertex in the second vertex set is less than a sum of the minimum distances between the second endpoints of the remaining first connection edges and each first vertex in the first vertex set and the minimum distances between the first endpoints and each second vertex in the second vertex set. Therefore, the first endpoints of the other remaining first connection edges are added into the first vertex set, and the second endpoints of the other remaining first connection edges are added into the second vertex set; and when the first cost value is greater than or equal to the second cost value, the first endpoints of the other remaining first connection edges are added into the second vertex set, and the second endpoints of the other remaining first connection edges are added into the first vertex set.

The explanation is continued from operation 1043 below with reference to FIG. 5A.

In operation 1044, other vertices in the first alpha wrapping result are classified into the first vertex set and the second vertex set.

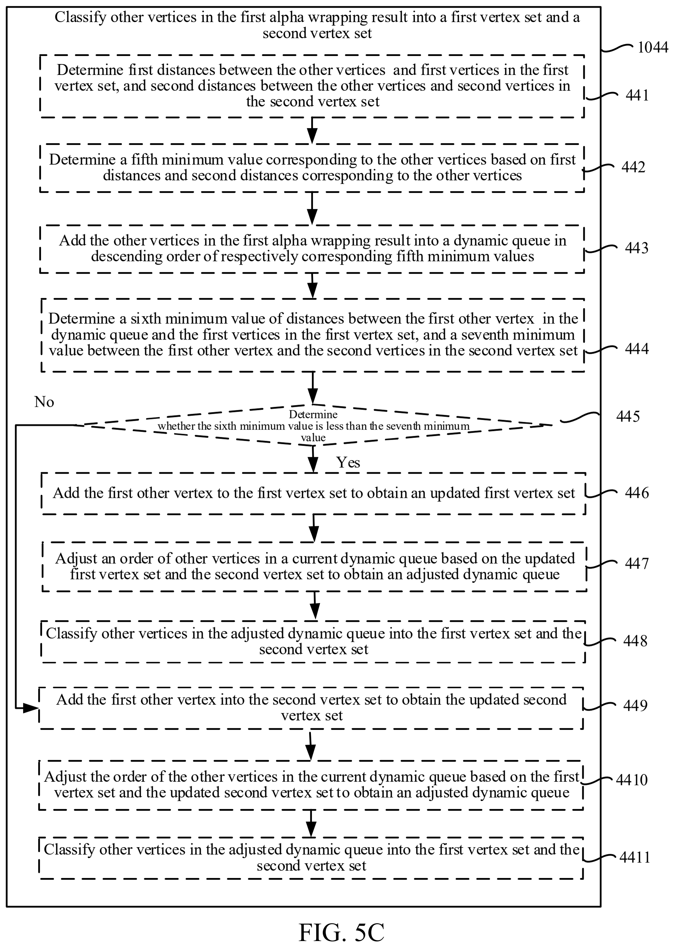

In some embodiments, as shown in FIG. 5C, operation 1044 may be implemented through the following operation 441 to operation 4411, and is specifically described below.

In operation 441, first distances between the other vertices and the first vertices in the first vertex set, and second distances between the other vertices and the second vertices in the second vertex set are determined.

In some embodiments, the first distances between the other vertices and the first vertices are determined based on the vertex coordinates of the other vertices and the vertex coordinates of the first vertices, and similarly, the second distances between the other vertices and the second vertices are determined based on the vertex coordinates of the other vertices and the vertex coordinates of the second vertices and based on a Euclidean distance calculation formula.

For example, three other vertices are provided, which are respectively C₁, C₂, and C₃; the first vertex set includes two first vertices, which are respectively A₁ and A₂; and the second vertex set includes three second vertices, which are respectively B₁, B₂, and B₃. Then, two first distances and three second distances may be determined for each other vertex.

In operation 442, fifth minimum values corresponding to the other vertices are determined based on the first distances and the second distances corresponding to the other vertices.

In some embodiments, a minimum distance is determined in the plurality of first distances and the plurality of second distances corresponding to the other vertices, and is determined as the fifth minimum value corresponding to other vertices.

Following the above example, one of the other vertices corresponds to two first distances and three second distances, then a minimum distance is determined from the five distance values, and the minimum distance is determined as the fifth minimum value corresponding to the other vertex.

In operation 443, other vertices in the first alpha wrapping result are added into a dynamic queue in descending order of respectively corresponding fifth minimum values.

After the fifth minimum values corresponding to the other vertices are determined, the plurality of other vertices are sorted in descending order of the fifth minimum values, and sequentially added into the dynamic queue. That is, the other vertex with the largest fifth minimum value is at the head of the queue, and the other vertex with the smallest fifth minimum value is at the tail of the queue.

For example, three other vertices are C₁, C₂, and C₃, corresponding fifth minimum values are 3, 1, and 8 respectively, and then the order in the dynamic queue is C₃, C₁, and C₂.

In operation 444, the sixth minimum value of distances between the first other vertex in the dynamic queue and each first vertex in the first vertex set, and the seventh minimum value between the first other vertex and each second vertex in the second vertex set are determined.

In some embodiments, because the first distances between the other vertices and the first vertices and the second distances between the other vertices and each second vertices are determined when the fifth minimum values corresponding to the other vertices are determined, then in this operation, a minimum value of the first distances corresponding to the first other vertex may be determined as the sixth minimum value, and a minimum value of the second distances corresponding to the first other vertex may be determined as the seventh minimum value.

Following the above example, the first other vertex is C₃. C₃ corresponds to two first distances, assumed to be 8 and 13. C₃ corresponds to three second distances, assumed to be 9, 10, and 11 respectively. Then, the sixth minimum value corresponding to the first other vertex is 8, and the seventh minimum value corresponding to the first other vertex is 9.

In operation 445, whether the sixth minimum value is less than the seventh minimum value is determined.

When the sixth minimum value is less than the seventh minimum value, operation 446 is performed, and when the sixth minimum value is greater than or equal to the seventh minimum value, operation 449 is performed.

In operation 446, the first other vertex is added to the first vertex set to obtain the updated first vertex set.

When the sixth minimum value is less than the seventh minimum value, the distance between the first other vertex and one of the first vertices in the first vertex set is the smallest, and then the first other vertex is added into the first vertex set to obtain the updated first vertex set.

Following the above example, the sixth minimum value of the first other vertex is 8, the seventh minimum value of the first other vertex is 9, and the sixth minimum value is less than the seventh minimum value; and therefore, the first other vertex is added into the first vertex set to obtain an updated first vertex set {C₃, A₁, A₂}.

In operation 447, an order of other vertices in the current dynamic queue is adjusted based on the updated first vertex set and the second vertex set to obtain an adjusted dynamic queue.

In some embodiments, adding the first other vertex into the first vertex set causes one other vertex to be missed from the current dynamic queue. Following the above example, in this case, the current dynamic queue is C₁ and C₂. In this case, third distances between the other vertices in the current dynamic queue and the first vertices in the updated first vertex set, and fourth distances between the other vertices in the current dynamic queue and the second vertices in the second vertex set are determined. Following the above example, because the updated first vertex set includes three first vertices, and the second vertex set still includes three second vertices, for each other vertex in the current dynamic queue, three third distances and three fourth distances can be determined, and then the eighth minimum values corresponding to other vertices in the current dynamic queue are determined based on each third distance and each fourth distance corresponding to other vertices in the current dynamic queue. Other vertices in the current dynamic queue are sorted in descending order of respectively corresponding eighth minimum values to obtain the adjusted dynamic queue.

In some embodiments, to avoid repeated calculation of the vertex distances, in operation 441, after the distance between two vertices is determined, the distance between the two vertices is stored into a caching space. When the distance between the two vertices needs to be determined again in a subsequent operation, whether the distance between the two vertices is stored into the caching space may be first determined. If the distance is stored, the distance is directly acquired from the caching space. If the distance is not stored, the distance between the two vertices is calculated and stored into the caching space, which can effectively reduce data calculation amount and improve processing efficiency.

In operation 448, other vertices in the adjusted dynamic queue are classified into the first vertex set and the second vertex set.

In some embodiments, operation 448 is implemented based on a process similar to operation 444 and operation 446. That is, after the adjusted dynamic queue is obtained, the first other vertex is taken out from the adjusted dynamic queue, then the minimum distance between the first other vertex and each first vertex in the updated first vertex set and the minimum distance between the first other vertex and each second vertex in the second vertex set are acquired, and the first other vertex is added into the vertex set corresponding to a smaller value of the two minimum distances. This process is repeated iteratively until all other vertices in the adjusted dynamic queue are classified into the first vertex set and the second vertex set.

In operation 449, the first other vertex is added into the second vertex set to obtain the updated second vertex set.

In operation 4410, the order of other vertices in the current dynamic queue are adjusted based on the first vertex set and the updated second vertex set to obtain an adjusted dynamic queue.

In operation 4411, other vertices in the adjusted dynamic queue are classified into the first vertex set and the second vertex set.

In some embodiments, an implementation process of operation 449 to operation 4411 is similar to an implementation process of operation 446 to operation 448, and for example, may refer to an implementation process of operation 446 to operation 448.

Through operation 1041 to operation 1044 above, when the to-be-processed component includes the first surface and the second surface that meet the parallel condition, that is, when the to-be-processed component has a double-layer structure, the vertices of the remaining first connection edges located inside the first alpha wrapping result are first classified into the first vertex set and the second vertex set, and then other vertices on the first alpha wrapping result are allocated to the first vertex set and the second vertex set, so as to subsequently construct the first surface and the second surface and provide a necessary data basis for subsequent coplanar fitting.

The explanation is continued from operation 104 below with reference to FIG. 4A.

In operation 105, coplanar fitting is performed on the first surface and the second surface based on the first vertex set and the second vertex set to obtain a target fitting result.

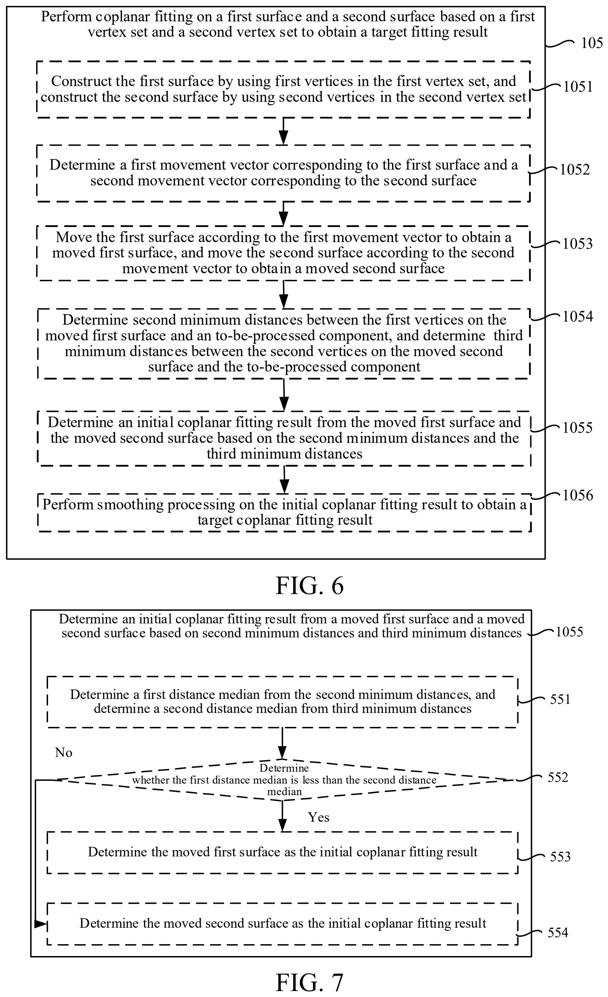

In some embodiments, as shown in FIG. 6, operation 105 may be implemented through the following operation 1051 to operation 1056, and is specifically described below.

In operation 1051, the first surface is constructed by using the first vertices in the first vertex set, and the second surface is constructed by using the second vertices in the second vertex set.

In some embodiments, first, a first patch set corresponding to a first vertex set and a second patch set corresponding to a second vertex set are acquired from the first alpha wrapping result. Where each first patch in the first patch set includes at least one first vertex, and similarly, each second patch in the second patch set includes at least one second vertex. Then, the first surface is constructed based on each first patch in the first patch set, and the second surface is constructed based on each second patch in the second patch set. When the first surface is constructed based on each first patch in the first patch set, the first patches having the same connection edges are spliced to obtain the first surface, and similarly, the second patches having the same connection edges are spliced to obtain the second surface.

In operation 1052, a first movement vector corresponding to the first surface and a second movement vector corresponding to the second surface are determined.

In some embodiments, a first weighted center of gravity of the first surface and a second weighted center of gravity of the second surface are determined, and a midpoint between the first weighted center of gravity and the second weighted center of gravity is determined; the first movement vector of the first surface is determined based on the midpoint and the first weighted center of gravity; and the second movement vector of the second surface is determined based on the midpoint and the second weighted center of gravity.

In some embodiments, when the first weighted center of gravity of the first surface is determined, first center of gravity coordinates of each first patch which forms the first surface, and the first area of each first patch are first determined, and the first area of each first patch is accumulated to obtain a total area of the first surface; then, the first areas are determined as first weight values of the first center of gravity coordinates, so that weighted summation is performed on the first center of gravity coordinates of each first patch and the first weight values to obtain first total center of gravity coordinates; and finally, the first weighted center of gravity is determined based on the first total center of gravity coordinates and the total area of the first surface. In some embodiments, the first total center of gravity coordinates may be divided by the total area of the first surface to obtain the first weighted center of gravity coordinates of the first weighted center of gravity. In this case, the first weighted center of gravity is determined. Because the first weighted center of gravity is determined based on the center of gravity coordinates of each first patch and the first areas of the first patches, and the center of gravity of the first patches having a larger area have greater impact on the weighted center of gravity of the first surface, the first weighted center of gravity coordinates of the first weighted center of gravity of the first surface can be determined more accurately.

In some embodiments, a determination mode of the second weighted center of gravity of the second surface is similar to a determination mode of the first weighted center of gravity. After the first weighted center of gravity coordinates of the first weighted center of gravity and the second weighted center of gravity coordinates of the second weighted center of gravity are known, average calculation may be performed on the first weighted center of gravity coordinates and the second weighted center of gravity coordinates to obtain midpoint coordinates of a midpoint between the first weighted center of gravity and the second weighted center of gravity.

The first weighted center of gravity coordinates of the first weighted center of gravity are subtracted from the midpoint coordinates of the midpoint to obtain the first movement vector of the first surface. Similarly, the second weighted center of gravity coordinates of the second weighted center of gravity are subtracted from the midpoint coordinates of the midpoint to obtain the second movement vector of the second surface.

In operation 1053, the first surface is moved according to the first movement vector to obtain a moved first surface, and the second surface is moved according to the second movement vector to obtain a moved second surface.

In some embodiments, the vertex coordinates of each first vertex in the first surface may be added with the first movement vector to obtain each moved first vertex, and the moved first surface is constructed based on each moved first vertex. Similarly, the vertex coordinates of each second vertex in the second surface may be added with the second movement vector to obtain each moved second vertex, so that the moved second surface is constructed based on each moved second vertex.

In operation 1054, second minimum distances between the first vertices on the moved first surface and the to-be-processed component are determined, and third minimum distances between the second vertices on the moved second surface and the to-be-processed component are determined.

In some embodiments, by using the library function provided by the CGAL, each second minimum distance between each first vertex on the moved first surface and the to-be-processed component, and each third minimum distance between each second vertex on the moved second surface and the to-be-processed component may be determined.

In operation 1055, an initial coplanar fitting result is determined from the moved first surface and the moved second surface based on the second minimum distances and the third minimum distances.

In some embodiments, as shown in FIG. 7, operation 1055 may be implemented through the following operation 551 to operation 554, and is specifically described below.

In operation 551, the first distance median is determined from each second minimum distance, and the second distance median is determined from each third minimum distance.

In some embodiments, the second minimum distances are sorted in ascending order to obtain a plurality of sorted second minimum distances, and then the second minimum distance located in the middle position of the plurality of sorted second minimum distances is determined as the first distance median. Assuming that N second minimum distances are provided, when N is an odd number, the first distance median is an (N+1)/2^{th} second minimum distance in the plurality of sorted second minimum distances, and when N is an even number, the first distance median is an (N/2)^{th} second minimum distance in the plurality of sorted second minimum distances.

Similarly, the third minimum distances are sorted in ascending order to obtain a plurality of sorted third minimum distances, and then the third minimum distance located in the middle position of the plurality of sorted third minimum distances is determined as the second distance median. Assuming that N third minimum distances are provided, when N is an odd number, the second distance median is an (N+1)/2^{th} third minimum distance in the plurality of sorted third minimum distances, and when N is an even number, the second distance median is an (N/2)^{th} third minimum distance in the plurality of sorted third minimum distances.

In operation 552, whether the first distance median is less than the second distance median is determined.

When the first distance median is less than the second distance median, operation 553 is performed; and when the first distance median is greater than or equal to the second distance median, operation 554 is performed.

In operation 553, the moved first surface is determined as the initial coplanar fitting result.

In operation 554, the moved second surface is determined as the initial coplanar fitting result.

In operation 551 to operation 554 above, the first distance median corresponding to the first surface and the second distance median corresponding to the second surface are determined, and a smaller distance median of the first distance median and the second distance median is taken as a basis for screening the initial coplanar fitting result. In this way, the impact of individual singular points on the coplanar fitting result may be eliminated.

In operation 1056, smoothing processing is performed on the initial coplanar fitting result to obtain a target coplanar fitting result.

In some embodiments, smoothing processing may be performed on the initial coplanar fitting result by using the library function provided by the CGAL to obtain a target coplanar fitting result. By performing further smoothing processing on the initial coplanar fitting result, the impact of bumpiness of the first alpha wrapping surface on the final target fitting result can be eliminated, so as to ensure that a smooth and glossy target coplanar fitting result is obtained. Moreover, through the target coplanar fitting result, an actual situation can be better reflected and a visual effect of a model can be improved, so that a 3D model determined by the target coplanar fitting result is smoother and more natural.

After the to-be-processed component is acquired, the first alpha wrapping result of the to-be-processed component is first determined, so as to obtain a flat, orientable, and bi-manifold watertight mesh model without self-intersection. Then, triangulation processing is performed on the first alpha wrapping result to obtain the triangulation processing result. Then, double-layer structure detection is performed on the to-be-processed component based on the triangulation processing result and the first alpha wrapping result. When the detection result indicates that the to-be-processed component includes the first surface and the second surface that meet the parallel condition, i.e., when the detection result indicates that the to-be-processed component has a double-layer structure, the vertices included in the first alpha wrapping result are grouped into the first vertex set located on the first surface and the second vertex set located on the second surface, so that coplanar fitting is performed on the first surface and the second surface based on the first vertex set and the second vertex set, to obtain the target fitting result, where the target fitting result has a single-layer structure. That is, in the method for processing the virtual component provided in the embodiments of this application, coplanar fitting may be performed on the to-be-processed component with a double-layer structure automatically to obtain the target fitting result with a single-layer structure, which can improve the robustness and the processing efficiency of coplanar fitting on the to-be-processed component with the double-layer structure.

An exemplary application of this embodiment of this application in an actual application scene will be described below.

The method for processing the virtual component provided in this embodiment of this application can also be applied to a rendering scene of a virtual model. After acquiring a 3D model of a virtual object, the terminal transmits the 3D model to the server; the server acquires model information, and determines each component included in the 3D model, which may include a garment component, an accessory component, a model body component, and the like; the server respectively determines each component included in the 3D model as a to-be-processed component, and then processes each to-be-processed component by using the method for processing the virtual component provided in this embodiment of this application; when determining that the to-be-processed component includes the first surface and the second surface that meet a parallel condition, coplanar fitting is performed on the first surface and the second surface to obtain a target fitting result; and coplanar fitting processing is not performed on a to-be-processed component that does not have the first surface and the second surface that meet a parallel condition, and the to-be-processed component is directly outputted. After the server performs double-layer detection on each to-be-processed component and performs fitting processing on the to-be-processed component having a double-layer structure, a processed 3D model is formed according to the target fitting result and other unprocessed to-be-processed components. The server transmits processed model information to the terminal. The terminal performs UV expansion processing on the processed model information to obtain a 2D expansion result of the processed 3D model, so as to perform 2D rendering based on the 2D expansion result. Because the component having the double-layer structure in the processed 3D model has been coplanarly fitted to a single-layer structure, the complexity of the 3D model can be greatly simplified while ensuring accuracy of the model structure, thereby improving the processing efficiency of UV expansion and 2D rendering.

The method for processing the virtual component provided in this embodiment of this application can also be applied to an automatic retopology project. Moreover, as long as an objective thereof is to use a single-layer structure for coplanar fitting, a model processing method provided in this embodiment of this application is also applicable and may be promoted.

In this embodiment of this application, a model processing method capable of implementing robust coplanar fitting is provided from the perspective of detection and separation of a double-layer structure. Implementation steps of the model processing method are described below.

### Operation I: Generate a flat alpha wrapping.

An original to-be-fitted model may often have problems such as no communication, self-intersecting, no orientability, and no bi-manifold, which may pose a great challenge to the robustness of subsequent processing operations. In addition, the original model is assumed to have a double-layer structure, but if a distance from the double-layer structure thereof is long, a robustness problem may also exist in subsequent processing procedures. To solve this problem, the original model is first preprocessed, to generate a flat alpha wrapping. Generating the flat alpha wrapping may be implemented through the following operations:
Operation 11): Generate, for the original model M, an initial alpha wrapping by using the first parameter value.

The initial alpha wrapping corresponds to the second alpha wrapping result in other embodiments. In some embodiments, the alpha wrapping may be calculated by using a method provided in the CGAL. Where the first parameter value includes the first value of the alpha parameter and the first value of the offset parameter. The first value of the alpha parameter may be 1/50 of the diagonal length of the AABB, and the first value of the offset parameter may be 1/100 of the diagonal length of the AABB.

Operation 12): Remesh the initial alpha wrapping, and then perform sampling respectively at vertices, edge midpoints, and centers of gravity of surfaces thereof to obtain a sampling point set.

Operation 13): Calculate an inward normal direction of each sampling point, generate a ray correspondingly, calculate an intersection point between the sampling point and the initial alpha wrapping, then calculate a midpoint between the sampling point and the intersection point, and store all the midpoints.

Operation 14): Take a midpoint set obtained in operation 13) as an input, and generate the flat alpha wrapping by using the second parameter value.

Where the second parameter value includes the second value of the alpha parameter and the first value of the offset parameter. The second value of the alpha parameter may be 1/100 of the diagonal length of the AABB, and the second value of the offset parameter may be 1/200 of the diagonal length of the AABB. That is, the second parameter value configured for generating the flat alpha wrapping in operation 14) is more accurate than the first parameter value configured for generating the initial alpha wrapping in operation 11).

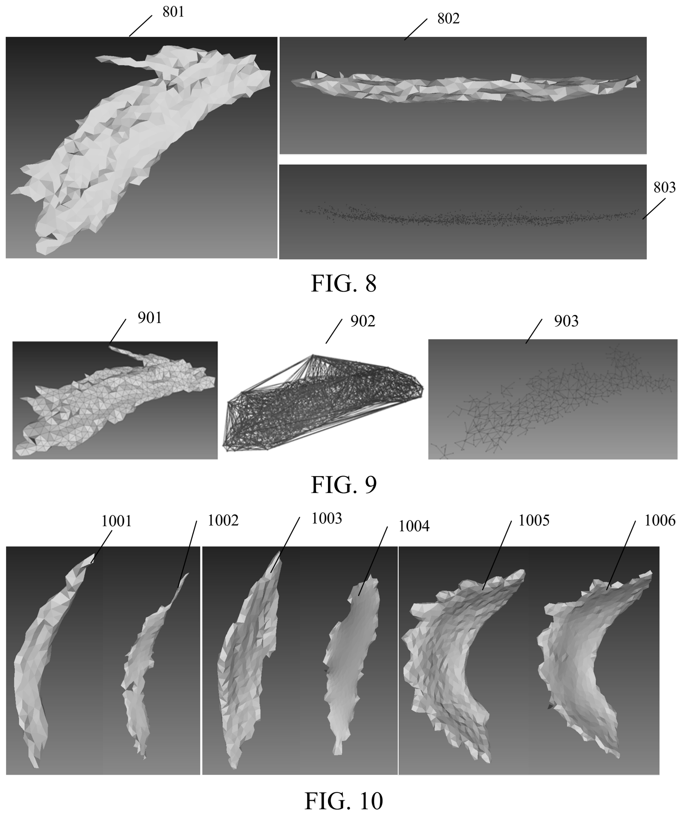

FIG. 8 is a schematic diagram of an original model and a generated flat alpha wrapping result provided in an embodiment of this application, where 801 in FIG. 8 is an original component, 802 is a side view of a flat alpha wrapping, and 803 is a corresponding midpoint set.

In operation 12) and operation 13), the sampling point set closer to the middle of the double-layer structure is obtained by calculating the midpoints of the sampling rays. In this way, the alpha wrapping generated again is flatter, so that a subsequent detection process of the double-layer structure is more robust.

In some embodiments, after the initial alpha wrapping result is generated, uniform sampling may further be performed in the internal space of the initial alpha wrapping. Then, for each sampling point, rays are emitted in different directions, and an intersection point between each ray and the original alpha wrapping is calculated. Next, the minimum value of the distances between the sampling points and the intersection points is calculated. If the minimum value is less than a preset distance threshold, the sampling point is close to the boundary of the initial alpha wrapping, and is discarded; otherwise, the sampling point is reserved. After all the sampling points are screened in this mode, the remaining sampling points may be configured to construct the flat alpha wrapping.

### Operation II: Detect a double-layer structure.

After the flat alpha wrapping is obtained, a robust algorithm needs to be designed to detect the double-layer structure, because only a model having a double-layer structure can use a single-layer structure to perform coplanar fitting. An embodiment of this application provides a double-layer structure detection algorithm based on 3D delaunay triangulation. An implementation process thereof is as follows:
Operation 21): Perform delaunay triangulation on all the vertices, serving as inputs, of the flat alpha wrapping in a 3D space, and mark a triangulation result as T in this embodiment of this application.
Operation 22): Deleting edges on T which are located outside the flat alpha wrapping result or on the surface, and only reserve edges located inside the flat alpha wrapping.

Because T obtained in operation 21) is triangulation of the convex hulls of the original vertices, the edges located outside the flat alpha wrapping and the edges on the surface of the flat alpha wrapping exist inevitably. Therefore, in operation 22), the two types of edges need to be deleted. For example, an AABB tree of the flat alpha wrapping is constructed. For the midpoint of each edge in T, a distance between the midpoint and the AABB tree is calculated. If the distance is less than a given threshold (a default value of 0.001), the edge is considered to be located on the surface of the flat alpha wrapping, and is directly deleted; otherwise, a ray method is configured for determining whether the midpoint is located inside the flat alpha wrapping; if not, the edge is an external edge, and is directly deleted; and if the midpoint is located inside the flat alpha wrapping, the edge is an internal edge, and is reserved.

FIG. 9 is a schematic diagram of a double-layer structure detection process provided in an embodiment of this application, where 901 in FIG. 9 is flat alpha wrapping, 902 is a 3D delaunay triangulation result, and 903 is a result after the external edges and the surface edges are deleted in operation 22) (i.e., only the internal edges are reserved).

Operation 23): Further delete the internal edges by calculating the first ratio of the geodesic distance to the Euclidean distance between two endpoints of each internal edge, and delete the internal edges if the first ratio is less than a set threshold.

All the internal edges of the alpha wrapping may be obtained through operation 22), but two endpoints of each internal edge located at the boundary of the double-layer structure may not belong to different layers of the double-layer structure, which may significantly interfere with subsequent classification of the double-layer structure. Therefore, in operation 23), screening is further performed through the ratio of the geodesic distance to the Euclidean distance between the endpoints of the internal edges to ensure that two endpoints of the remaining internal edges belong to different layers of the double-layer structure. A basic thought of this algorithm is: The Euclidean distance between the endpoints of the internal edges located at the boundary of the double-layer structure is often not much different from the geodesic distance. However, geodesics of the endpoints of the internal edges located at the central part of the double-layer structure need to pass through the edges of the entire double-layer structure, and thus are significantly longer than the Euclidean distance. Therefore, in this embodiment of this application, the first ratio of the geodesic distance to the Euclidean distance between two endpoints of the internal edges is determined, whether the first ratio is less than a set threshold is determined, and if the first ratio is less than the set threshold, the internal edge is deleted, where a default threshold of the first ratio may be 3, or may be 4, 4.5, and the like.

Operation 24): Calculate the second ratio of the quantity of internal edges obtained in operation 23) to the quantity of internal edges obtained in operation 22); if the second ratio is less than a given threshold (which may be 0.4 for example), consider that the original model does not have a double-layer structure, that is, coplanar fitting cannot be performed by using a single-layer structure, and return false; otherwise, record final remaining internal edges, and return true.

Through observation and experimental verification, it is found that for a model having a double-layer structure, only a small quantity of internal edges located at the boundaries can be deleted in operation 23), and for a model having no double-layer structure, a large quantity of internal edges are deleted because the distance ratio is less than the threshold. Therefore, in operation 24), the proportion of the deleted internal edges is calculated to determine whether the original model has a double-layer structure, and subsequent classification and fitting may be performed only when a model having a double-layer structure exists.

### Operation III: Classify the double-layer structure.

After processing and screening in operation II, data that enter the current operation may be ensured to have the following characteristics: (1) the current flat alpha wrapping certainly has a double-layer structure; and 2) the endpoints of remaining internal edges necessarily belong to different layers of the double-layer structure. Based on the characteristics, an embodiment of this application provides a double-layer structure classification method based on vertex grouping. An implementation process includes the following operations:
Operation 31): Sort the remaining internal edges of the previous operation in descending order of the geodesic distances between the endpoints of the internal edges.
Operation 32): Classify a starting point of the first edge into {A} and an ending point into {B}.
Operation 33): Sequentially process the remaining internal edges, and classify the endpoints of the internal edges respectively into a set {A} and a set {B}.

In operation 33), for example, first assuming that the endpoints of a current internal edge are S and T, only two alternative cases exist: in the first case, S is put into the set {A}, and T is put into the set {B}; and in the second case, S is put into the set {B}, and T is put into the set {A}. Then, a minimum value of distances from S to all elements in the set {A} and a minimum value of distances from T to all elements in the set {B} are calculated respectively, and a sum of the two minimum values is taken as the cost of the alternative case 1. The cost of the alternative case 2 may be calculated by using a similar method, and then the alternative case with small cost is selected as the final classification of S and T. That is, if the cost of the case 1 is less than the cost of the case 2, classification is performed according to the case 1, i.e., S is put into the set {A}, and T is put into the set {B}. Similarly, if the cost of the case 2 is less than or equal to the cost of the case 1, classification is performed according to the case 2, i.e., S is put into the set {B}, and T is put into the set {A}.

Operation 34): Sequentially process the remaining vertices in the flat alpha wrapping, and classify the remaining vertices into the set {A} or the set {B}.

In operation 33), the endpoints of the remaining internal edges are classified, while the vertices on the flat alpha wrapping are still not classified. Therefore, in operation 34), the vertices are continued to be classified by a specific method of: first putting the remaining vertices into a dynamic priority queue in descending order according to the minimum values of the distances from the elements in the vertex sets {A} and {B} (i.e., the vertex with the largest minimum value of the distance is ranked first), and then sequentially processing the vertices. In an actual application process, the minimum values of the distances between the vertices and all the elements in {A} and {B} are calculated. If the vertices are closer to {A}, the vertices are classified into the set {A}, and the current dynamic priority queue is adjusted according to updated {A}; and if the vertices are closer to {B}, the vertices are classified into the set {B}, and the current dynamic priority queue is adjusted according to updated {B}. Processing is continued in this way until all the vertices on the flat alpha wrapping are classified into {A} or {B}.

### Operation IV: Generate and optimize a single-layer structure.

After robust binary classification is performed on the vertices on the flat alpha wrapping, a single-layer structure may be generated and optimized. An implementation process of operation IV includes:
Operation 41): Construct a patch set {F_{A}} adjacent to the vertices in the set {A}, and a patch set {F_{B}} adjacent to the vertices in the set {B} respectively;
Operation 42): Construct single-layer structures M_{A} and M_{B} respectively by using {F_{A}} and {F_{B}};
Operation 43): Calculate the weighted centers of gravity C_{A} and C_{B} of M_{A} and M_{B} respectively; and calculate a midpoint C therebetween;
Operation 44): Move M_{A} by vector V_{A}=C-C_{A} and move M_{B} by vector V_{B}=C-C_{B};
Operation 45): Calculate the shortest distances from the vertices on M_{A} and M_{B} to the original model respectively, and take the median of the distances; if the median of the shortest distance from the endpoint on M_{A} to the original model is less than the median of the shortest distance from the endpoint on M_{B} to the original model, then select M_{A} as the initial fitting result of the single-layer structure; otherwise, select M_{B} as the initial fitting result of the single-layer structure;

In operation 45), the median of the shortest distances of all the vertices is taken as a basis for screening the initial result of single-layer optimization, so that the impact of individual singular points on the final result can be eliminated.

Operation 46): Mark the boundaries of the initial fitting result of single-layer optimization, and then perform the internal smoothing operation with boundary protection to obtain the final coplanar fitting result.

The initial result of the single-layer result is further optimized in operation 46), so as to eliminate the impact of bumpiness of the fat alpha wrapping surface on the final fitting result.

FIG. 10 is a schematic comparison diagram of original to-be-processed components having a double-layer structure and coplanar fitting results corresponding to the original to-be-processed components provided in an embodiment of this application, where 1001, 1003, and 1005 are the original to-be-processed components, 1002 is the coplanar fitting result corresponding to the original to-be-processed component shown by 1001, 1004 is the coplanar fitting result of the original to-be-processed component shown by 1003, and 1006 is the coplanar fitting result of the original to-be-processed component shown by 1005. As shown in FIG. 10, no matter whether the to-be-processed component having the double-layer structure is curved, a best fitting of a single-layer structure may be determined by using the method for processing the virtual component provided in this embodiment of this application.

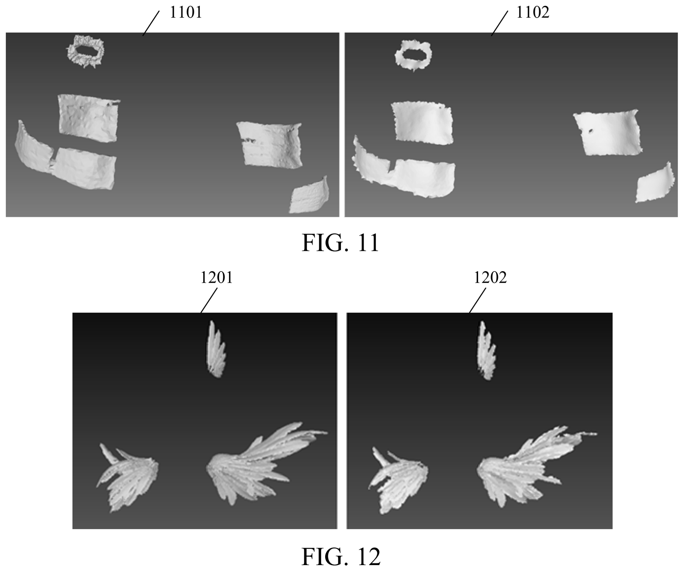

FIG. 11 is a schematic comparison diagram of cut piece structures and coplanar fitting results corresponding to the cut piece structures provided in an embodiment of this application, where 1101 shows an original cut piece structure, and 1102 shows the coplanar fitting results of the original cut piece structures. FIG. 12 is a schematic comparison diagram of feather components having a double-layer structure and coplanar fitting results corresponding to the feather components provided in an embodiment of this application, where 1201 shows original feather components, and 1202 shows the coplanar fitting results corresponding to the feather components. From FIG. 11 and FIG. 12, by using the method provided in the present disclosure, coplanar fitting for a specific type of models may be implemented, and the fitting results not only satisfy requirements of a single-layer structure, but also may be non-planar or even of any curvature. With the coplanar fitting results of the single-layer structure, in subsequent processing by retopology tools, only retopology is required for the fitting results. Therefore, complete automation of retopology of the components having the double-layer structure may be implemented.

An exemplary structure of the apparatus 455 for processing the virtual component, implemented as a software module, provided in an embodiment of this application is continued to be described below. In some embodiments, as shown in FIG. 2, the software module, stored in a memory 450, in the apparatus 455 for processing the virtual component may include: a preprocessing module 4551, configured to acquire a to-be-processed component, and perform preprocessing on the to-be-processed component to obtain the first alpha wrapping result of the to-be-processed component; a triangulation processing module 4552, configured to perform triangulation processing on the first alpha wrapping result to obtain a triangulation processing result; a double-layer structure detection module 4553, configured to perform double-layer structure detection on the to-be-processed component based on the triangulation processing result and the first alpha wrapping result to obtain a detection result; a vertex grouping module 4554, configured to group vertices included in the first alpha wrapping result into the first vertex set located on the first surface and the second vertex set located on the second surface when the detection result indicates that the to-be-processed component includes the first surface and the second surface that meet a parallel condition; and a coplanar fitting module 4555, configured to perform coplanar fitting on the first surface and the second surface based on the first vertex set and the second vertex set to obtain a target fitting result.

In some embodiments, the preprocessing module 4551 is further configured to: acquire the first processing parameter value, and generate an initial alpha wrapping result of the to-be-processed component by using the first processing parameter value; determine a plurality of target points based on the initial alpha wrapping result, the target points being located inside the initial alpha wrapping result; and acquire the second processing parameter value, and generate the first alpha wrapping result of the to-be-processed component by using the second processing parameter value and the plurality of target points, the second processing parameter value being less than the first processing parameter value.

In some embodiments, the preprocessing module 4551 is further configured to: perform meshing processing on the initial alpha wrapping result to obtain a meshed alpha wrapping result; determine vertices, midpoints of connection edges, and a center of gravity of triangular patches in the meshed alpha wrapping result as first sampling points; determine a normal of each first sampling point towards an interior of the meshed alpha wrapping result, and determine intersection points between the normals and the meshed alpha wrapping result; and determine a midpoint between each first sampling point and the corresponding intersection point, and determine the midpoints as the target point.

In some embodiments, the preprocessing module 4551 is further configured to: perform uniform sampling in an internal space of the initial alpha wrapping result to obtain a plurality of second sampling points; determine first minimum distances between the second sampling points and the initial alpha wrapping result; and determine the second sampling points having the first minimum distances greater than or equal to a preset first distance threshold as the target points.

In some embodiments, the triangulation processing result includes vertices and the connection edges of triangular patches, and the double-layer structure detection module 4553 is further configured to: determine a plurality of first connection edges located inside the first alpha wrapping result and the first edge quantity of the first connection edges in the triangulation processing result; determine the first ratio of a geodesic distance to a Euclidean distance corresponding to each first connection edge; delete the first connection edges having the first ratios less than the first ratio threshold from the plurality of first connection edges to obtain a plurality of remaining first connection edges; determine the second edge quantity of the remaining first connection edges, and determine the second ratio of the second edge quantity to the first edge quantity; determine, when the second ratio is greater than or equal to the second ratio threshold, that a detection result is that the to-be-processed component includes the first surface and the second surface that meet the parallel condition; and determine, when the second ratio is less than the second ratio threshold, that the detection result is that the to-be-processed component does not include the first surface and the second surface that meet the parallel condition.

In some embodiments, the vertex grouping module 4554 is further configured to: sort the plurality of remaining first connection edges in descending order of respectively corresponding geodesic distances to obtain a plurality of sorted remaining first connection edges; add the first endpoint of the first remaining first connection edges in the plurality of sorted remaining first connection edges to the first vertex set, and add the second endpoint of the first remaining first connection edges to the second vertex set; classify two endpoints of other remaining first connection edges other than the first remaining first connection edges in the sorted remaining first connection edges respectively into the first vertex set and the second vertex set; and classify other vertices in the first alpha wrapping result into the first vertex set and the second vertex set.

In some embodiments, the vertex grouping module 4554 is further configured to: determine the first minimum value of distances between the first endpoints of the other remaining first connection edges and first vertices in the first vertex set; determine the second minimum value of distances between second endpoints of the other remaining first connection edges and second vertices in the second vertex set; determine a sum of the first minimum value and the second minimum value as the first cost value; determine the third minimum value of distances between the first endpoints of the other remaining first connection edges and each second vertex in the second vertex set; determine the fourth minimum value of distances between the second endpoints of the other remaining first connection edges and each first vertex in the first vertex set; determine a sum of the third minimum value and the fourth minimum value as the second cost value; and classify two endpoints of the other remaining first connection edges respectively into the first vertex set and the second vertex set based on the first cost value and the second cost value.

In some embodiments, the vertex grouping module 4554 is further configured to: add the first endpoints of the other remaining first connection edges into the first vertex set, and add the second endpoints of the other remaining first connection edges into the second vertex set when the first cost value is less than the second cost value; and add the first endpoints of the other remaining first connection edges into the second vertex set, and add the second endpoints of the other remaining first connection edges into the first vertex set when the first cost value is greater than or equal to the second cost value.

In some embodiments, the vertex grouping module 4554 is further configured to: determine first distances between the other vertices and the first vertices in the first vertex set, and second distances between the other vertices and the second vertices in the second vertex set; determine the fifth minimum values corresponding to the other vertices based on the first distances and the second distances corresponding to the other vertices; add the other vertices in the first alpha wrapping result into a dynamic queue in descending order of respectively corresponding fifth minimum values; determine a sixth minimum value of distances between the first other vertex in the dynamic queue and each first vertex in the first vertex set, and the seventh minimum value between the first other vertex and each second vertex in the second vertex set; add the first other vertex to the first vertex set when the sixth minimum value is less than the seventh minimum value to obtain an updated first vertex set; adjust an order of other vertices in a current dynamic queue based on the updated first vertex set and the second vertex set to obtain an adjusted dynamic queue; and classify other vertices in the adjusted dynamic queue into the first vertex set and the second vertex set.

In some embodiments, the vertex grouping module 4554 is further configured to: add the first other vertex into the second vertex set when the sixth minimum value is greater than or equal to the seventh minimum value to obtain an updated second vertex set; adjust the order of other vertices in the current dynamic queue based on the first vertex set and the updated second vertex set to obtain an adjusted dynamic queue; and classify other vertices in the adjusted dynamic queue into the first vertex set and the second vertex set.

In some embodiments, the vertex grouping module 4554 is further configured to: determine each third distance between other vertices in the current dynamic queue and each first vertex in the updated first vertex set, and each fourth distance between other vertices in the current dynamic queue and each second vertex in the second vertex set; determine fifth minimum values corresponding to the other vertices in the current dynamic queue based on the first distances and the second distances corresponding to other vertices in the current dynamic queue; and sort the other vertices in the current dynamic queue in descending order of the respectively corresponding fifth minimum values to obtain the adjusted dynamic queue.

In some embodiments, the coplanar fitting module 4555 is further configured to: construct the first surface by using the first vertices in the first vertex set, and construct the second surface by using the second vertices in the second vertex set; determine the first movement vector corresponding to the first surface and the second movement vector corresponding to the second surface; move the first surface according to the first movement vector to obtain a moved first surface, and move the second surface according to the second movement vector to obtain a moved second surface; determine each second minimum distance between each first vertex on the moved first surface and the to-be-processed component, and determine each third minimum distance between each second vertex on the moved second surface and the to-be-processed component; determine an initial coplanar fitting result from the moved first surface and the moved second surface based on the each second minimum distance and the each third minimum distance; and perform smoothing processing on the initial coplanar fitting result to obtain a target coplanar fitting result.

In some embodiments, the coplanar fitting module 4555 is further configured to: acquire the first patch set adjacent to the first vertices in the first vertex set from the first alpha wrapping result and the second patch set adjacent to the second vertices in the second vertex set; construct the first surface based on first patches in the first patch set; and construct the second surface based on second patches in the second patch set.

In some embodiments, the coplanar fitting module 4555 is further configured to: determine the first weighted center of gravity of the first surface and the second weighted center of gravity of the second surface, and determine a midpoint between the first weighted center of gravity and the second weighted center of gravity; determine the first movement vector of the first surface based on the midpoint and the first weighted center of gravity; and determine the second movement vector of the second surface based on the midpoint and the second weighted center of gravity.

In some embodiments, the coplanar fitting module 4555 is further configured to: determine first center of gravity coordinates of the first patches which form the first surface, first areas of the first patches, and a total area of the first surface; determine the first area as a first weight value of the first center of gravity coordinates; determine first total center of gravity coordinates based on the first center of gravity coordinates of the first patches and the first weight value; and determine the first weighted center of gravity based on the first total center of gravity coordinates and the total area of the first surface.

In some embodiments, the coplanar fitting module 4555 is further configured to: determine a first distance median from the second minimum distances, and determine a second distance median from the third minimum distances; determine the moved first surface as the initial coplanar fitting result when the first distance median is less than the second distance median; and determine the moved second surface as the initial coplanar fitting result when the first distance median is greater than or equal to the second distance median.

In some embodiments, the triangulation processing module 4552 is further configured to: call a preset triangulation function, and perform triangulation processing on the first alpha wrapping result to obtain the triangulation processing result.

An embodiment of this application provides a computer program product including a computer program or computer-executable instructions, the computer program or the computer-executable instructions being stored in a computer-readable storage medium. A processor of an electronic device reads the computer-executable instructions from the computer-readable storage medium and executes the computer-executable instructions, to cause the electronic device to perform the method for processing the virtual component in this embodiment of this application.

An embodiment of this application provides a computer-readable storage medium, having computer-executable instructions stored therein, where the computer-executable instructions or computer programs are stored, and when executed by a processor, the computer-executable instructions or the computer programs cause the processor to perform the method for processing the virtual component, such as the method for processing the virtual component shown in FIG. 4A, provided in this embodiment of this application.

In some embodiments, the computer-readable storage medium may be a memory such as a random access memory (RAM), a read only memory (ROM), a flash memory, a magnetic surface memory, an optical disk, or a CD-ROM, or may be any device including one of or any combination of the above memories.

In some embodiments, the computer-executable instructions may be written in a form of a program, software, a software module, a script, or codes and according to a programming language (including a compiled or interpreted language, or a declarative or procedural language) in any form, and may be deployed in any form, including being deployed as an independent program or being deployed as a module, a component, a subroutine, or other units suitable for use in a computing environment.

In an example, the computer-executable instructions may, but do not necessarily, correspond to files in a file system, may be stored in a part of a file that saves other programs or data, and for example, stored in one or more scripts in a hyper text markup language (HTML) document, stored in a single file dedicated to a program under discussion, or stored in a plurality of collaborative files (for example, files that store one or more modules, subprograms, or code portions).

In an example, the computer-executable instructions may be deployed to be executed on an electronic device, or executed on a plurality of electronic devices at the same location, or executed on a plurality of electronic devices distributed in a plurality of locations and interconnected by a communication network.

The above only describes the embodiments of this application and is not intended to limit a protection scope of this application. Any modification, equivalent replacement, improvement, etc. made within the spirit and the scope of this application are to be included within the protection scope of this application.

## Claims

1. A method for processing a virtual object, applied to an electronic device, and the method comprising:
acquiring a to-be-processed object, and performing preprocessing on the to-be-processed object to obtain a first alpha wrapping result of the to-be-processed object;
performing triangulation processing on the first alpha wrapping result to obtain a triangulation processing result;
performing double-layer structure detection on the to-be-processed object based on the triangulation processing result and the first alpha wrapping result to obtain a detection result;
grouping vertices comprised in the first alpha wrapping result into a first vertex set located on a first surface and a second vertex set located on a second surface when the detection result indicates that the to-be-processed object comprises the first surface and the second surface that meet a parallel condition; and
performing coplanar fitting on the first surface and the second surface based on the first vertex set and the second vertex set to obtain a target fitting result of the to-be-processed object.

2. The method according to claim 1, wherein the performing preprocessing on the to-be-processed object to obtain a first alpha wrapping result of the to-be-processed object comprises:
acquiring a first processing parameter value, and generating a second alpha wrapping result of the to-be-processed object by using the first processing parameter value;
determining a plurality of target points based on the second alpha wrapping result, the target points being located inside the second alpha wrapping result; and
acquiring a second processing parameter value, and generating the first alpha wrapping result of the to-be-processed object by using the second processing parameter value and the plurality of target points, the second processing parameter value being less than the first processing parameter value.

3. The method according to claim 2, wherein the determining a plurality of target points based on the second alpha wrapping result comprises:
performing meshing processing on the second alpha wrapping result to obtain a meshed alpha wrapping result;
determining vertices, midpoints of connection edges, and a center of gravity of triangular patches in the meshed alpha wrapping result as first sampling points;
determining a normal of each first sampling point towards an interior of the meshed alpha wrapping result, and determining intersection points between the normals and the meshed alpha wrapping result; and
determining a midpoint between each first sampling point and the corresponding intersection point, and determining the midpoints as the target points.

4. The method according to claim 2, wherein the determining a plurality of target points based on the second alpha wrapping result comprises:
performing uniform sampling in an internal space of the second alpha wrapping result to obtain a plurality of second sampling points;
determining first minimum distances between the second sampling points and the second alpha wrapping result; and
determining second sampling points having the first minimum distances greater than or equal to a preset first distance threshold as the target points.

5. The method according to claim 1, wherein the triangulation processing result comprises vertices and the connection edges of triangular patches, and the performing double-layer structure detection on the to-be-processed object based on the triangulation processing result and the first alpha wrapping result to obtain a detection result comprises:
determining a plurality of first connection edges located inside the first alpha wrapping result and a first edge quantity of the first connection edges in the triangulation processing result;
determining a first ratio of a geodesic distance to a Euclidean distance corresponding to each first connection edge;
deleting first connection edges having the first ratios less than a first ratio threshold from the plurality of first connection edges to obtain a plurality of remaining first connection edges;
determining a second edge quantity of the remaining first connection edges, and determining a second ratio of the second edge quantity to the first edge quantity;
determining, when the second ratio is greater than or equal to a second ratio threshold, that a detection result is that the to-be-processed object comprises the first surface and the second surface that meet the parallel condition; and
determining, when the second ratio is less than the second ratio threshold, that the detection result is that the to-be-processed object does not comprise the first surface and the second surface that meet the parallel condition.

6. The method according to claim 5, wherein the grouping vertices comprised in the first alpha wrapping result into a first vertex set located on a first surface and a second vertex set located on a second surface comprises:
sorting the plurality of remaining first connection edges in descending order of respectively corresponding geodesic distances to obtain a plurality of sorted remaining first connection edges;
adding a first endpoint of the first remaining first connection edges in the plurality of sorted remaining first connection edges to the first vertex set, and adding a second endpoint of the first remaining first connection edges to the second vertex set;
classifying two endpoints of other remaining first connection edges other than the first remaining first connection edges in the sorted remaining first connection edges respectively into the first vertex set and the second vertex set; and
classifying other vertices in the first alpha wrapping result into the first vertex set and the second vertex set.

7. The method according to claim 6, wherein the classifying two endpoints of other remaining first connection edges other than the first remaining first connection edges in the sorted remaining first connection edges respectively into the first vertex set and the second vertex set comprises:
determining a first minimum value of distances between first endpoints of the other remaining first connection edges and first vertices in the first vertex set;
determining a second minimum value of distances between second endpoints of the other remaining first connection edges and second vertices in the second vertex set;
determining a sum of the first minimum value and the second minimum value as a first cost value;
determining a third minimum value of distances between the first endpoints of the other remaining first connection edges and the second vertices in the second vertex set;
determining a fourth minimum value of distances between the second endpoints of the other remaining first connection edges and the first vertices in the first vertex set;
determining a sum of the third minimum value and the fourth minimum value as a second cost value; and
classifying two endpoints of the other remaining first connection edges respectively into the first vertex set and the second vertex set based on the first cost value and the second cost value.

8. The method according to claim 7, wherein the classifying two endpoints of the other remaining first connection edges respectively into the first vertex set and the second vertex set based on the first cost value and the second cost value comprises:
adding the first endpoints of the other remaining first connection edges into the first vertex set, and adding the second endpoints of the other remaining first connection edges into the second vertex set when the first cost value is less than the second cost value; and
adding the first endpoints of the other remaining first connection edges into the second vertex set, and adding the second endpoints of the other remaining first connection edges into the first vertex set when the first cost value is greater than or equal to the second cost value.

9. The method according to claim 6, wherein the classifying other vertices in the first alpha wrapping result into the first vertex set and the second vertex set comprises:
determining first distances between the other vertices and the first vertices in the first vertex set, and second distances between the other vertices and the second vertices in the second vertex set;
determining a fifth minimum value corresponding to the other vertices based on the first distances and the second distances corresponding to the other vertices;
adding the other vertices in the first alpha wrapping result into a dynamic queue in descending order of respectively corresponding fifth minimum values;
determining a sixth minimum value of distances between the first other vertex in the dynamic queue and the first vertices in the first vertex set, and a seventh minimum value between the first other vertex and the second vertices in the second vertex set;
adding the first other vertex to the first vertex set when the sixth minimum value is less than the seventh minimum value to obtain an updated first vertex set;
adjusting an order of other vertices in a current dynamic queue based on the updated first vertex set and the second vertex set to obtain an adjusted dynamic queue; and
classifying other vertices in the adjusted dynamic queue into the first vertex set and the second vertex set.

10. The method according to claim 9, wherein the classifying other vertices in the first alpha wrapping result into the first vertex set and the second vertex set comprises:
adding the first other vertex into the second vertex set when the sixth minimum value is greater than or equal to the seventh minimum value to obtain an updated second vertex set;
adjusting the order of other vertices in the current dynamic queue based on the first vertex set and the updated second vertex set to obtain an adjusted dynamic queue; and
classifying other vertices in the adjusted dynamic queue into the first vertex set and the second vertex set.

11. The method according to claim 9, wherein the adjusting an order of other vertices in a current dynamic queue based on the updated first vertex set and the second vertex set to obtain an adjusted dynamic queue comprises:
determining third distances between the other vertices in the current dynamic queue and the first vertices in the updated first vertex set, and fourth distances between the other vertices in the current dynamic queue and the second vertices in the second vertex set;
determining fifth minimum values corresponding to the other vertices in the current dynamic queue based on the first distances and the second distances corresponding to other vertices in the current dynamic queue, and
sorting the other vertices in the current dynamic queue in descending order of the respectively corresponding fifth minimum values to obtain the adjusted dynamic queue.

12. The method according to any one of claims 1 to 11, wherein the performing coplanar fitting on the first surface and the second surface based on the first vertex set and the second vertex set to obtain a target fitting result of the to-be-processed object comprises:
constructing the first surface by using the first vertices in the first vertex set, and constructing the second surface by using the second vertices in the second vertex set;
determining a first movement vector corresponding to the first surface and a second movement vector corresponding to the second surface;
moving the first surface according to the first movement vector to obtain a moved first surface, and moving the second surface according to the second movement vector to obtain a moved second surface;
determining second minimum distances between the first vertices on the moved first surface and the to-be-processed object, and determining third minimum distances between the second vertices on the moved second surface and the to-be-processed object;
determining an initial coplanar fitting result from the moved first surface and the moved second surface based on the second minimum distances and the third minimum distances; and
performing smoothing processing on the initial coplanar fitting result to obtain a target coplanar fitting result of the to-be-processed object.

13. The method according to claim 12, wherein the constructing the first surface by using the first vertices in the first vertex set, and constructing the second surface by using the second vertices in the second vertex set comprises:
acquiring a first patch set corresponding to the first vertex set and a second patch set corresponding to the second vertex set from the first alpha wrapping result, each first patch in the first patch set comprising at least one first vertex, and each second patch in the second patch set comprising at least one second vertex; and
constructing the first surface based on first patches in the first patch set, and constructing the second surface based on second patches in the second patch set.

14. The method according to claim 12, wherein the determining a first movement vector corresponding to the first surface and a second movement vector corresponding to the second surface comprises:
determining a first weighted center of gravity of the first surface and a second weighted center of gravity of the second surface, and determining a midpoint between the first weighted center of gravity and the second weighted center of gravity;
determining the first movement vector of the first surface based on the midpoint and the first weighted center of gravity; and
determining the second movement vector of the second surface based on the midpoint and the second weighted center of gravity.

15. The method according to claim 14, wherein the determining a first weighted center of gravity of the first surface comprises:
determining first center of gravity coordinates of the first patches which form the first surface, first areas of the first patches, and a total area of the first surface;
determining the first area as a first weight value of the first center of gravity coordinates;
determining first total center of gravity coordinates based on the first center of gravity coordinates of the first patches and the first weight value; and
determining the first weighted center of gravity based on the first total center of gravity coordinates and the total area of the first surface.

16. The method according to claim 12, wherein the determining an initial coplanar fitting result from the moved first surface and the moved second surface based on the second minimum distances and the third minimum distances comprises:
determining a first distance median from the second minimum distances, and determining a second distance median from the third minimum distances;
determining the moved first surface as the initial coplanar fitting result when the first distance median is less than the second distance median; and
determining the moved second surface as the initial coplanar fitting result when the first distance median is greater than or equal to the second distance median.

17. The method according to any one of claims 1 to 16, wherein the performing triangulation processing on the first alpha wrapping result to obtain a triangulation processing result comprises:
calling a preset triangulation function, and performing triangulation processing on the first alpha wrapping result to obtain the triangulation processing result.

18. An apparatus for processing a virtual object, comprising:
a preprocessing module, configured to acquire a to-be-processed object, and perform preprocessing on the to-be-processed object to obtain a first alpha wrapping result of the to-be-processed object;
a triangulation processing module, configured to perform triangulation processing on the first alpha wrapping result to obtain a triangulation processing result;
a double-layer structure detection module, configured to perform double-layer structure detection on the to-be-processed object based on the triangulation processing result and the first alpha wrapping result to obtain a detection result;
a vertex grouping module, configured to group vertices comprised in the first alpha wrapping result into a first vertex set located on a first surface and a second vertex set located on a second surface when the detection result represents that the to-be-processed object comprises the first surface and the second surface that meet a parallel condition; and
a coplanar fitting module, configured to perform coplanar fitting on the first surface and the second surface based on the first vertex set and the second vertex set to obtain a target fitting result of the to-be-processed object.

19. An electronic device, comprising:
a memory, configured to store computer-executable instructions; and
a processor, configured to, when executing the computer-executable instructions stored in the memory, implement the method for processing the virtual object according to any one of claims 1 to 17.

20. A computer-readable storage medium, having computer-executable instructions or a computer program stored therein, the computer-executable instructions or the computer program, when executed by a processor, implementing the method for processing the virtual object according to any one of claims 1 to 21.

21. A computer program product, comprising computer-executable instructions or a computer program, the computer-executable instructions or the computer program, when executed by a processor, implementing the method for processing the virtual object according to any one of claims 1 to 17.
